(19) Europäisches Patentamt
European Patent Office
Office européen des brevets

(11) EP 4 219 154 A1

(12) **EUROPEAN PATENT APPLICATION**
published in accordance with Art. 153(4) EPC

(43) Date of publication:
**02.08.2023 Bulletin 2023/31**

(21) Application number: **22864758.2**

(22) Date of filing: **05.09.2022**

(51) International Patent Classification (IPC):
***B32B 27/00*** (2006.01) ***B32B 27/36*** (2006.01)
***C09J 153/00*** (2006.01) ***C09J 201/00*** (2006.01)
***C09J 7/25*** (2018.01) ***C09J 7/29*** (2018.01)
***C09J 7/38*** (2018.01) ***B32B 7/022*** (2019.01)
***B32B 7/023*** (2019.01)

(52) Cooperative Patent Classification (CPC):
**B32B 7/022; B32B 7/023; B32B 27/00; B32B 27/36; C09J 7/25; C09J 7/29; C09J 7/38; C09J 153/00; C09J 201/00**

(86) International application number:
**PCT/JP2022/033300**

(87) International publication number:
**WO 2023/033176 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.09.2021 JP 2021144763**

(71) Applicant: **SEKISUI CHEMICAL CO., LTD.**
**530-0047 (JP)**

(72) Inventors:
- **UCHIDA, Noriyuki**
  **Inukami-gun, Shiga 522-0314 (JP)**
- **GOTOU, Takuma**
  **Mishima-gun, Osaka 618-0021 (JP)**

(74) Representative: **Cabinet Beau de Loménie**
**158, rue de l'Université**
**75340 Paris Cedex 07 (FR)**

(54) **ADHESIVE TAPE FOR SEMICONDUCTOR DEVICE MANUFACTURING**

(57) The present invention aims to provide an adhesive tape for semiconductor device production which exhibits excellent chip component separability and can reduce adhesive deposits on chip components. Provided is an adhesive tape for semiconductor device production, including: a substrate; an ablation layer; a barrier layer; and a first adhesive layer in this order.

EP 4 219 154 A1

## Description

### TECHNICAL FIELD

The present invention relates to an adhesive tape for semiconductor device production.

### BACKGROUND ART

The production process of semiconductor devices may include transferring of a large number of chip components arranged on an adhesive layer onto a drive circuit board.

For example, micro-LED displays are display devices in which each chip constituting a pixel is a micro light emitting diode (LED) chip and the micro-LED chip emits light by itself to display an image. Micro-LED displays are attracting attention as the next generation of display devices owing to their high contrast, fast response speed, and capability to be thinner because they do not require color filters used in display devices such as liquid crystal displays and organic EL displays. In micro-LED displays, a large number of micro-LED chips are densely laid out in a plane.

In the production process of such a semiconductor device including micro-LED displays, for example, a transfer laminate in which a large number of chip components are arranged on an adhesive layer is opposed to a drive circuit board, and the chip components are separated from the transfer laminate to be electrically connected to the drive circuit board (transfer process).

A known method for separating the chip components from the transfer laminate is, for example, irradiation of the transfer laminate with laser light focused on the adhesive layer from the back surface of the support of the transfer laminate (see, for example, Patent Literature 1). Such a method is also called laser ablation. In another known method, heat-expandable materials such as heat-expandable particles and heat-expandable microcapsules are blended in the adhesive layer. The heat-expandable materials are thermally expanded by heat compression bonding of the transfer laminate and the drive circuit board to deform the adhesive layer, whereby the contact area is decreased to separate the chip components (for example, Patent Literatures 2 and 3).

### CITATION LIST

- Patent Literature

Patent Literature 1: JP 2019-138949 A
Patent Literature 2: JP 2019-15899 A
Patent Literature 3: JP 2003-7986 A

### SUMMARY OF INVENTION

- Technical Problem

However, conventional methods for separating chip components are disadvantageous in that transfer of chip components with a good yield is difficult due to separation failures of the chip components.

Laser ablation using a conventional adhesive layer disadvantageously leaves a residue of the adhesive layer to the chip components. In other words, even if an increase in output of laser light in laser ablation enables separation itself of the chip components, the adhesive layer is torn off upon separation of the chip components, leaving a residue of the adhesive layer on the chip components.

The present invention aims to provide an adhesive tape for semiconductor device production which exhibits excellent chip component separability and can reduce adhesive deposits on chip components.

- Solution to Problem

The present disclosure 1 is an adhesive tape for semiconductor device production, including: a substrate; an ablation layer; a barrier layer; and a first adhesive layer in this order.

The present disclosure 2 is the adhesive tape for semiconductor device production according to the present disclosure 1, wherein the substrate is a resin film.

The present disclosure 3 is the adhesive tape for semiconductor device production according to the present disclosure 2, wherein the resin film is a polyester film.

The present disclosure 4 is the adhesive tape for semiconductor device production according to the present disclosure 1, 2, or 3, wherein the ablation layer has a UV absorbance at a wavelength of 365 nm of 90% or higher.

The present disclosure 5 is the adhesive tape for semiconductor device production according to the present disclosure 1, 2, 3, or 4, wherein the ablation layer has a storage modulus G' at 23°C of $1 \times 10^4$ Pa or more and $2 \times 10^5$ Pa or less.

The present disclosure 6 is the adhesive tape for semiconductor device production according to the present disclosure 1, 2, 3, 4, or 5, wherein the barrier layer has a thickness of 25 um or less.

The present disclosure 7 is the adhesive tape for semiconductor device production according to the present disclosure 6, wherein the barrier layer has a thickness of 6 um or less.

The present disclosure 8 is the adhesive tape for semiconductor device production according to the present disclosure 1, 2, 3, 4, 5, 6, or 7, wherein the barrier layer is a polyester film.

The present disclosure 9 is the adhesive tape for semiconductor device production according to the present disclosure 1, 2, 3, 4, 5, 6, 7, or 8, wherein the barrier layer has an easy-adhesion resin layer on a surface in contact with the first adhesive layer.

The present disclosure 10 is the adhesive tape for semiconductor device production according to the present disclosure 1, 2, 3, 4, 5, 6, 7, 8, or 9, wherein the first adhesive layer has a breaking strength of 1 MPa or more.

The present disclosure 11 is the adhesive tape for semiconductor device production according to the present disclosure 1, 2, 3, 4, 5, 6, 7, 8, 9, or 10, wherein the first adhesive layer has a storage modulus G' at 23°C of $1 \times 10^4$ Pa or more and $2 \times 10^5$ Pa or less.

The present disclosure 12 is the adhesive tape for semiconductor device production according to the present disclosure 1, 2, 3, 4, 5, 6, 7, 8, 9, 10, or 11, wherein the first adhesive layer contains an ABA block copolymer.

The present disclosure 13 is the adhesive tape for semiconductor device production according to the present disclosure 12, wherein the ABA block copolymer includes a block A containing a structure derived from an aromatic vinyl monomer and a block B containing a structure derived from a (meth)acrylic monomer.

The present disclosure 14 is the adhesive tape for semiconductor device production according to the present disclosure 12 or 13, wherein the block B has a structure derived from a crosslinkable functional group-containing monomer.

The present disclosure 15 is the adhesive tape for semiconductor device production according to the present disclosure 1, 2, 3, 4, 5, 6, 7, 8, 9, 10, 11, 12, 13, or 14, wherein the first adhesive layer has a gel fraction of 70% by weight or more and 95% by weight or less.

The present disclosure 16 is the adhesive tape for semiconductor device production according to the present disclosure 1, 2, 3, 4, 5, 6, 7, 8, 9, 10, 11, 12, 13, 14, or 15, wherein the first adhesive layer has a thickness of 5 um or more and 30 um or less.

The present disclosure 17 is the adhesive tape for semiconductor device production according to the present disclosure 1, 2, 3, 4, 5, 6, 7, 8, 9, 10, 11, 12, 13, 14, 15, or 16, wherein the adhesive tape for semiconductor device production has a ball tack value of 5 or higher.

The present disclosure 18 is the adhesive tape for semiconductor device production according to the present disclosure 1, 2, 3, 4, 5, 6, 7, 8, 9, 10, 11, 12, 13, 14, 15, 16, or 17, wherein the first adhesive layer in the adhesive tape for semiconductor device production has a surface peel strength of 1 MPa or less.

The present disclosure 19 is the adhesive tape for semiconductor device production according to the present disclosure 1, 2, 3, 4, 5, 6, 7, 8, 9, 10, 11, 12, 13, 14, 15, 16, 17, or 18, wherein an adhesion between the substrate and the ablation layer is 6 N/25 mm or more.

The present disclosure 20 is the adhesive tape for semiconductor device production according to the present disclosure 1, 2, 3, 4, 5, 6, 7, 8, 9, 10, 11, 12, 13, 14, 15, 16, 17, 18, or 19, wherein an adhesion between the ablation layer and the barrier layer is 6 N/25 mm or more.

The present disclosure 21 is the adhesive tape for semiconductor device production according to the present disclosure 1, 2, 3, 4, 5, 6, 7, 8, 9, 10, 11, 12, 13, 14, 15, 16, 17, 18, 19, or 20, wherein the first adhesive layer is a curable adhesive layer.

The present disclosure 22 is the adhesive tape for semiconductor device production according to the present disclosure 1, 2, 3, 4, 5, 6, 7, 8, 9, 10, 11, 12, 13, 14, 15, 16, 17, 18, 19, 20, or 21, further including a second adhesive layer, wherein the adhesive tape for semiconductor device production includes the second adhesive layer, the substrate, the ablation layer, the barrier layer, and the first adhesive layer in this order.

The present disclosure 23 is the adhesive tape for semiconductor device production according to the present disclosure 1, 2, 3, 4, 5, 6, 7, 8, 9, 10, 11, 12, 13, 14, 15, 16, 17, 18, 19, 20, 21, or 22, which is for use in production of a semiconductor device, the production including a step of irradiation with laser light.

The present invention will be described in detail below.

The present inventors found that an adhesive tape for semiconductor device production including a substrate, an ablation layer, a barrier layer, and a first adhesive layer in this order can facilitate separation of chip components

from the tape and reduce adhesive deposits left on the chip components in the case of separating chip components by laser ablation. Thus, the present invention was completed.

The adhesive tape for semiconductor device production of the present invention includes a substrate, an ablation layer, a barrier layer, and a first adhesive layer in this order.

When the ablation layer of the adhesive tape for semiconductor device production of the present invention is irradiated with laser light, the irradiated portion of the ablation layer is deformed by ablation. The deformation of the irradiated portion of the ablation layer reaches the barrier layer and the first adhesive layer, which allows separation of the chip components on the first adhesive layer. At this time, scattering of the ablation layer due to ablation is reduced by the barrier layer. The adhesive tape for semiconductor device production of the present invention thus can exhibit improved chip component separability and prevent tearing of the first adhesive layer upon separation of the chip components to prevent adhesion of a residue of the first adhesive layer to the chip components.

FIG. 1 shows a cross-sectional view schematically illustrating an exemplary step of separating chip components on an adhesive layer by laser abrasion using a conventional adhesive tape. In the process shown in FIG. 1, chip components 1 are on an adhesive layer 4 laminated on a substrate 5, and one chip component 1 is separated by laser light 8a emitted from a laser light irradiation device 8 to electrically connect the chip component 1 and a drive circuit board 7 (transfer step). A laminate 9 including the substrate 5 and the adhesive layer 4 may be, for example, a conventional single-sided adhesive tape including the substrate 5 that is a substrate such as a resin film and the adhesive layer 4 consisting only of an adhesive layer, or a laminate including a support and a double-sided adhesive tape, including the substrate 5 that is a support such as a glass substrate and the adhesive layer 4 that is a conventional double-sided adhesive tape (which may include a substrate).

In the process shown in FIG. 1, when the adhesive layer 4 is irradiated with the laser light 8a, the portion of the adhesive layer 4 irradiated with the laser light 8a is deformed by ablation. More specifically, when the adhesive layer 4 is irradiated with the laser light 8a, the molecules of the adhesive layer 4 are cut by the heat to have a lower molecular weight, and the resulting molecules are instantaneously evaporated or sublimated due to high temperature (decomposition evaporation). Thereby, the portion of the adhesive layer 4 irradiated with the laser light 8a is deformed, which enables separation of the chip components 1. Use of the laser light 8a allows separation of the chip components 1 within a very small area. Even in the case where very small chip components such as micro-LED chips are arranged, for example, each chip component can be individually separated with high separability. However, in the process shown in FIG. 1, separation failures of the chip components 1 or adhesion of a residue of the adhesive layer 4 torn off upon separation of the chip components 1 to the chip components 1 may occur as described above.

FIG. 2 shows a cross-sectional view schematically illustrating an example of the adhesive tape for semiconductor device production of the present invention. In an adhesive tape 12 for semiconductor device production of the present invention shown in FIG. 2, a substrate 5, an ablation layer 10, a barrier layer 11, and a first adhesive layer 4a are laminated in this order.

FIG. 3 shows a cross-sectional view schematically illustrating an example of a step of separating chip components on an adhesive layer by laser ablation using the adhesive tape for semiconductor device production of the present invention. In the process shown in FIG. 3, the chip components 1 are on the first adhesive layer 4a and separated by the laser light 8a emitted from the laser light irradiation device 8 as in the process shown in FIG. 1. However, in the process shown in FIG. 3, irradiation of the ablation layer 10 with the laser light 8a allows deformation of the portion of the ablation layer 10 irradiated with the laser light 8a by ablation. The deformation of the portion of the ablation layer 10 irradiated with the laser light 8a reaches the barrier layer 11 and the first adhesive layer 4a, which allows separation of the chip components 1 on the first adhesive layer 4a. At this time, scattering of the ablation layer 10 due to ablation is reduced by the barrier layer 11.

Including the substrate, the adhesive tape for semiconductor device production of the present invention has appropriate stiffness and is excellent in handleability.

The substrate may be any substrate. From the standpoint of separation of chip components by laser ablation, preferred is a substrate having an appropriate UV transmittance. The substrate may have any UV transmittance. The lower limit of the UV transmittance at a wavelength of 365 nm is preferably 1%, more preferably 50%, still more preferably 80%. The upper limit of the UV transmittance at a wavelength of 365 nm is not limited. The practical upper limit is approximately 95%.

The UV transmittance of the substrate at a wavelength of 365 nm can be measured in conformity with JIS L1925 using, for example, a spectrophotometer (UV-2600i, available from Shimadzu Corporation, or its equivalent product).

The substrate is preferably a resin film in order to adjust the UV transmittance at a wavelength of 365 nm to the above range.

The resin film may be any resin film. Preferred is a polyester film having excellent heat resistance. Examples of the polyester film include a polyethylene terephthalate film, a polyethylene naphthalate film, and a polybutylene terephthalate film. Among them, a polyethylene terephthalate film is preferred. The resin film is preferably an acrylic

resin film having excellent UV transmittance. Examples of the acrylic resin film include a film made of polymethyl methacrylate. Examples of the resin film also include a polyacetal film, a polyamide film, a polycarbonate film, a polyphenylene ether film, an ultrahigh-molecular-weight polyethylene film, a syndiotactic polystyrene film, a polyarylate film, a polysulfone film, a polyether sulfone film, a polyphenylene sulfide film, a polyetheretherketone film, a polyimide film, a polyether imide film, a fluororesin film, and a liquid crystal polymer film.

The substrate may have any thickness. The lower limit of the thickness is preferably 5 um and the upper limit thereof is preferably 188 um. With the substrate having a thickness within the above range, the adhesive tape can have appropriate stiffness and excellent handleability. The lower limit of the thickness of the substrate is more preferably 12 um and the upper limit thereof is more preferably 100 $\mu$m.

The substrate may have any haze. Still, a smaller haze is preferred in order to allow efficient transmission of laser light to improve the chip component separability. The upper limit of the haze of the substrate is preferably 10%, more preferably 5%, still more preferably 1%. The lower limit of the haze of the substrate is not limited and the smaller the better. The practical lower limit is approximately 0.1%.

The haze of the substrate can be measured using, for example, a haze meter (NDH4000, available from Nippon Denshoku Industries Co., Ltd.).

The ablation layer may be any layer that undergoes deformation by ablation when irradiated with laser light. The ablation layer may or may not have adhesiveness.

The ablation layer preferably has an appropriate UV absorbance to be deformed by ablation when irradiated with laser light. The UV absorbance of the ablation layer at a wavelength of 365 nm is not limited but the lower limit thereof is preferably 90%, more preferably 99%. In the ablation layer having a UV absorbance at a wavelength of 365 nm within the above range, the stimulus of the laser light is efficiently converted to heat or vibration, so that a deformation by ablation is likely to occur, leading to further improvement of the chip component separability of the adhesive tape for semiconductor device production. The upper limit of the UV absorbance at a wavelength of 365 nm is not limited. The practical upper limit is approximately 99.9%.

The UV absorbance of the ablation layer at a wavelength of 365 nm can be measured in conformity with JIS L1925 using, for example, a spectrophotometer (UV-2600i, available from Shimadzu Corporation, or its equivalent product).

The ablation layer preferably contains a UV absorber in order to adjust the UV absorbance at a wavelength of 365 nm to the above range.

The UV absorber may be any UV absorber such as a benzotriazole UV absorber or a hydroxyphenyltriazine UV absorber. Examples of the UV absorber also include ethylhexyl methoxycinnamate, octyl methoxycinnamate, ethylhexyl paramethoxycinnamate, hexyl diethylamino hydroxybenzoyl benzoate, bis-ethylhexyloxyphenol methoxyphenyl triazine, and t-butyl methoxydibenzoylmethane. Preferred among them are a benzotriazole UV absorber and a hydroxyphenyltriazine UV absorber because they have excellent compatibility with other components in the ablation layer. These UV absorbers may be used alone, or two or more of them may be used in combination.

The amount of the UV absorber is not limited. The lower limit thereof is preferably 4 parts by weight relative to 100 parts by weight of a base polymer contained in the ablation layer. When the amount of the UV absorber is 4 parts by weight or more, the adhesive tape for semiconductor device production has better chip component separability. The lower limit of the amount of the UV absorber is more preferably 6 parts by weight, still more preferably 8 parts by weight, even more preferably 10 parts by weight, furthermore preferably 15 parts by weight.

The upper limit of the amount of the UV absorber is not limited. From the standpoint of secure bonding between the ablation layer and the substrate or barrier layer, the upper limit of the amount is preferably 30 parts by weight. In the case of insufficient bonding between the ablation layer and the substrate or barrier layer, troubles may occur. For example, the adhesive tape for semiconductor device production cut to a desired tape width may suffer partial detachment between the ablation layer and the substrate or barrier layer at the cut end (end detachment).

The ablation layer may have any storage modulus (shear storage modulus) G' at 23°C and 1 Hz. The lower limit the storage modulus G' is preferably $1 \times 10^4$ Pa and the upper limit thereof is preferably $2 \times 10^5$ Pa. With the storage modulus G' within the above range, the ablation layer can be appropriately deformed by ablation when irradiated with laser light, leading to further improvement of the chip component separability of the adhesive tape for semiconductor device production. The lower limit of the storage modulus G' is more preferably $1.5 \times 10^4$ Pa and the upper limit thereof is more preferably $1.5 \times 10^5$ Pa. The lower limit is still more preferably $2.0 \times 10^4$ Pa and the upper limit is still more preferably $1.0 \times 10^5$ Pa.

The storage modulus G' of the ablation layer at 23°C and 1 Hz can be determined as a storage modulus at 23°C in measurement of a dynamic viscoelasticity spectrum from - 40°C to 140°C under the conditions of 1 Hz in a simple heating mode of a heating rate of 5°C/min using a viscoelastic spectrometer (available from IT Keisoku Seigyo Co., Ltd., DVA-200, or its equivalent product), for example.

The ablation layer may or may not have adhesiveness. From the standpoint of secure bonding between the ablation layer and the substrate for, for example, reducing troubles including the end detachment, the adhesion between

the substrate and the ablation layer is preferably 6 N/25 mm or more, more preferably 10 N/25 mm or more. The upper limit of the adhesion between the substrate and the ablation layer is not limited but is preferably 50 N/25 mm.

From the standpoint of secure bonding between the ablation layer and the barrier layer for, for example, reducing troubles including the end detachment, the adhesion between the ablation layer and the barrier layer is preferably 6 N/25 mm or more, more preferably 10 N/25 mm or more. The upper limit of the adhesion between the ablation layer and the barrier layer is not limited but is preferably 50 N/25 mm.

The adhesion herein can be determined by measuring the 180° adhesion (N/25 mm) in a peeling test in which a sample is peeled off in a 180° direction at a tensile speed of 300 mm/min in an environment at a temperature of 23°C and a relative humidity of 50% in conformity with JIS Z0237 using a device such as Autograph (available from Shimadzu Corporation), for example.

Examples of the base polymer contained in the ablation layer include an ABA block copolymer, an acrylic copolymer, a urethane copolymer, and a silicone adhesive. Preferred among them are an ABA block copolymer and an acrylic copolymer because they facilitate adjustment of the storage modulus G' of the ablation layer to the above range to further improve the chip component separability of the adhesive tape for semiconductor device production. In order to avoid excessive ablation generated at the irradiated portion upon irradiation of the ablation layer with laser light, more preferred is an ABA block copolymer. In order to achieve secure bonding between the ablation layer and the substrate or barrier layer to, for example, reduce troubles such as the end detachment, an acrylic copolymer is more preferred.

The ABA block copolymer and the acrylic copolymer, as the base polymer contained in the ablation layer, may be the same as the ABA block copolymer and the acrylic copolymer described later, as the base polymer contained in the first adhesive layer.

When the base polymer contained in the ablation layer is an ABA block copolymer, the SP value of the B block copolymer is not limited but is preferably 9.5 or higher. When the SP value is 9.5 or higher, the adhesiveness between the substrate and the barrier layer is improved, so that the ablation layer is less likely to be detached when ablation occurs, leading to further improvement of the chip component separability. The SP value is more preferably 9.6 or higher, still more preferably 9.8 or higher. The upper limit of the SP value is not limited. The practical upper limit is approximately 14 because synthesis becomes difficult.

The SP value is called a solubility parameter and is a parameter used as an index of polarity. Herein, the Fedors method (R. F. Fedors, Polym. Eng. Sci., 14(2), 147-154 (1974)) is used for calculating the SP value. The SP value of the B block copolymer of the ABA block copolymer can be calculated based on the SP values of respective repeating units in the B block in the copolymer and the compounding ratio (molar ratio) of the repeating units.

The ablation layer may have any thickness. The lower limit of the thickness is preferably 3 um and the upper limit thereof is preferably 50 um. With the thickness within the above range, the ablation layer can be appropriately deformed by ablation when irradiated with laser light, leading to further improvement of the chip component separability of the adhesive tape for semiconductor device production. The lower limit of the thickness of the ablation layer is more preferably 5 um and the upper limit thereof is more preferably 30 um. The lower limit is still more preferably 8 um and the upper limit is still more preferably 20 μm.

The ablation layer may have any gel fraction. The lower limit of the gel fraction is preferably 70% by weight and the upper limit thereof is preferably 95% by weight. When the gel fraction is 70% by weight or more, the adhesive tape for semiconductor device production exhibits better chip component separability. When the gel fraction is 95% by weight or less, the adhesive tape for semiconductor device production exhibits better chip component holdability. The lower limit of the gel fraction is more preferably 80% by weight and the upper limit thereof is more preferably 90% by weight.

The gel fraction of the ablation layer can be measured by the following method.

The ablation layer (ablation layer composition) alone in an amount of 0.1 g is taken out from the adhesive tape for semiconductor device production, immersed in 50 mL of ethyl acetate, and shaken using a shaker under the conditions of a temperature of 23°C and 200 rpm for 24 hours. After the shaking, a metal mesh (#200 mesh) is used to separate ethyl acetate and the ablation layer composition that has been swollen by absorbing ethyl acetate. The separated ablation layer composition is dried under the condition of 110°C for one hour. The weight of the ablation layer composition including the metal mesh after being dried is measured, and the gel fraction of the ablation layer is calculated using the following equation.

$$\text{Gel fraction (\% by weight)} = 100 \times (W_1 - W_2)/W_0$$

($W_0$: the initial weight of the ablation layer composition,
$W_1$: the weight of the ablation layer composition including the metal mesh after being dried, $W_2$: the initial weight of the metal mesh)

When the ablation layer composition is not completely dissolved in ethyl acetate, a solvent such as toluene,

hexane, or water is used instead of ethyl acetate. Specifically, when the ablation layer composition contains a styrene elastomer, for example, toluene or hexane is used. When the ablation layer composition contains polyvinyl alcohol, hot water at 90°C is used.

The barrier layer may be any layer that can be deformed according to the deformation of the portion of the ablation layer irradiated with laser light while suppressing scattering of the ablation layer. The barrier layer is preferably a resin film because a resin film can be deformed according to the deformation of the portion of the ablation layer irradiated with laser light while suppressing scattering of the ablation layer.

The resin film may be any resin film. Preferred are a polyester film and a polyolefin film because they can be deformed according to the deformation of the portion of the ablation layer irradiated with laser light while suppressing scattering of the ablation layer. More preferred is a polyester film. Examples of the polyester film include a polyethylene terephthalate film, a polyethylene naphthalate film, and a polybutylene terephthalate film. Examples of the polyolefin film include a polyethylene film, an unstretched polypropylene film, a biaxially stretched polypropylene film, a cycloolefin polymer film, and a cycloolefin copolymer film.

Examples of the resin film also include an acrylic resin film, a polyacetal film, a polyamide film, a polycarbonate film, a polyphenylene ether film, a syndiotactic polystyrene film, a polyarylate film, a polysulfone film, a polyethersulfone film, a polyphenylene sulfide film, a polyetheretherketone film, a polyimide film, a polyetherimide film, a fluororesin film, and a liquid crystal polymer film.

The barrier layer preferably has an easy-adhesion-treated layer on a surface in contact with the first adhesive layer. The presence of the easy-adhesion-treated layer improves bonding between the barrier layer and the first adhesive layer. The easy-adhesion-treated layer may be any layer such as a corona-treated layer and a primer-treated layer.

The barrier layer may have any thickness. The lower limit of the thickness is preferably 1 um and the upper limit thereof is preferably 25 um. With the barrier layer having a thickness of 1 um or more, scattering of the ablation layer can be sufficiently suppressed. The barrier layer having a thickness of 25 um or less can be sufficiently deformed according to the deformation of the portion of the ablation layer irradiated with laser light, further improving the chip component separability of the adhesive tape for semiconductor device production. The lower limit of the thickness is more preferably 2 um and the upper limit thereof is more preferably 10 μm, still more preferably 6 μm.

The barrier layer may have any haze, preferably a small haze in order to improve the visibility and facilitate exact irradiation of the intended part of the chip with laser light, leading to further improvement of the chip component separability. The upper limit of the haze of the barrier layer is preferably 10%, more preferably 5%, still more preferably 1%. The lower limit of the haze is not limited and the smaller the better. The practical lower limit is approximately 0.1%.

The haze of the barrier layer can be measured using, for example, a haze meter (NDH4000, available from Nippon Denshoku Industries Co., Ltd.).

The barrier layer may have an easy-adhesion resin layer on the surface in contact with the first adhesive layer. With the easy-adhesion resin layer, the barrier layer more closely contacts the first adhesive layer, and the first adhesive layer is less likely to be separated from the barrier layer when the chip is transferred, reducing generation of adhesive deposits on the chip.

The resin forming the easy-adhesion resin layer is not limited, and examples thereof include polyester resins, polyurethane resins, and nitrile rubbers.

The easy-adhesion resin layer may further contain known additives such as a plasticizer, a resin, a surfactant, a wax, and a fine particle filler. These additives may be used alone, or two or more thereof may be used in combination.

The modulus of elasticity (MPa) of the easy-adhesion resin layer as determined by a nanoindentation method is not limited. The lower limit thereof is preferably 4,000 MPa and the upper limit thereof is preferably 10,000 MPa. The modulus of elasticity of the resin layer as determined by a nanoindentation method is determined, for example, as follows. A load-displacement hysteresis curve is obtained by a single indentation method using a nanoindenter (Triboindenter TI-950 available from Hysitron Inc.) at a predetermined temperature (25°C). In the method, a Berkovich diamond indenter (in a triangular pyramid shape) is perpendicularly pressed against a measurement target layer under the measurement conditions of an indentation speed of 400 nm/sec and, a withdrawal speed of 400 nm/sec, and an indentation depth of 100 nm. The obtained load-displacement hysteresis curve is subjected to numerical processing using software (triboscan) included with the measurement device, whereby the modulus of elasticity is determined.

The easy-adhesion resin layer may have any thickness. The lower limit of the thickness is preferably 0.05 um and the upper limit thereof is preferably 0.3 um. With the easy-adhesion resin layer having a thickness of 0.05 um or more, the barrier layer can more closely contact the first adhesive layer. With the adhesion resin layer having a thickness of 0.3 um or less, the barrier layer is easily deformed upon ablation, further improving the chip component separability. The lower limit of the thickness of the easy-adhesion resin layer is more preferably 0.08 um and the upper limit thereof is more preferably 0.2 um. The lower limit is still more preferably 0.1 um and the upper limit is still more preferably 0.18 μm.

The first adhesive layer may be any layer. Preferably, the first adhesive layer is a pressure-sensitive adhesive layer. In order to further improve the chip component separability, the first adhesive layer may be a curable adhesive layer such as a thermosetting adhesive layer or a photo-curable adhesive layer.

Examples of a base polymer contained in the first adhesive layer include an ABA block copolymer, an acrylic copolymer, a urethane copolymer, and a silicone adhesive. Preferred among them are an ABA block copolymer and an acrylic copolymer because they facilitate adjustment of the properties of the first adhesive layer, such as the breaking strength, the storage modulus G', and the gel fraction, to the ranges described later, further improves the chip component separability of the adhesive tape for semiconductor device production, and further reduces adhesive deposits on the chip components. From the same standpoint, more preferred is an ABA block copolymer.

The ABA block copolymer is a copolymer including a block A having a rigid structure (hereinafter also referred to as "hard segment") and a block B having a flexible structure (hereinafter also referred to as "soft segment").

The two blocks in the ABA block copolymer are hardly compatible with each other. The ABA block copolymer may have a heterogeneous phase separation structure including the sea of the block B interspersed with spherical islands formed by cohesion of the block A, or a heterogeneous phase separation structure including the sea of the block B interspersed with cylindrical structures formed by cohesion of the block A. Such a phase separation structure interspersed with spherical islands is also called a spherical phase separation structure, and the phase separation structure interspersed with cylindrical structures is also called a cylindrical phase separation structure. Since the islands of the phase separation structure serve as pseudo-crosslinking points, the ABA block copolymer can have rubber elasticity, which facilitates adjustment of the properties of the first adhesive layer, such as the breaking strength, the storage modulus G', and the gel fraction, to the ranges described later, further improves the chip component separability of the adhesive tape for semiconductor device production, and further reduces adhesive deposits on the chip components.

The ABA block copolymer is preferably an ABA triblock copolymer.

In the ABA block copolymer, the block A may be any block that has a rigid structure. Still, the block A preferably contains a structure derived from an aromatic vinyl monomer.

The block A may further contain, in addition to the structure derived from an aromatic vinyl monomer, a structure derived from, for example, a compound having a cyclic structure or a compound having a short side-chain substituent, as long as the effect of the present invention is not impaired.

Examples of the aromatic vinyl monomer include styrene, alpha-methylstyrene, paramethylstyrene, and chlorostyrene. These aromatic vinyl monomers may be used alone, or two or more thereof may be used in combination. Preferred among these is styrene, because it can further improve the chip component separability of the adhesive tape for semiconductor device production and can further reduce adhesive deposits on the chip components. The structure derived from an aromatic vinyl monomer herein refers to a structure represented by the following formula (1) or (2).

[Chem. 1]

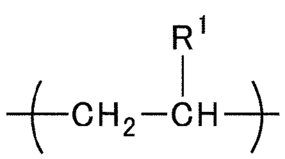 ( 1 ) 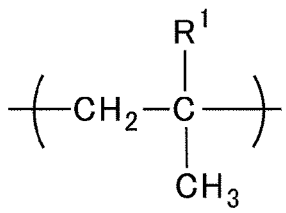 ( 2 )

In the formulas (1) and (2), $R^1$ represents an aromatic ring-containing substituent. Examples of the aromatic ring-containing substituent $R^1$ include a phenyl group, a methylphenyl group, and a chlorophenyl group.

The amount of the structure derived from an aromatic vinyl monomer in the ABA block copolymer is not limited and is preferably 1% by weight or more and 30% by weight or less. When the amount of the structure derived from an aromatic vinyl monomer is within the above range, the breaking strength of the first adhesive layer is increased, further reducing adhesive deposits on the chip components. The lower limit of the amount of the structure derived from an aromatic vinyl monomer is more preferably 5% by weight, still more preferably 8% by weight, particularly preferably 10% by weight, and the upper limit thereof is more preferably 28% by weight, still more preferably 25% by weight, particularly preferably 20% by weight.

In the ABA block copolymer, the block B may be any block that has a flexible structure. The block B preferably contains a structure derived from a conjugated diene monomer or a structure derived from a (meth)acrylic monomer because it facilitates adjustment of the properties of the first adhesive layer, such as the breaking strength, the storage modulus G', and the gel fraction, to the ranges described later. The block B more preferably contains a structure derived from a (meth)acrylic monomer, because the first adhesive layer can have more appropriate tackiness, and the adhesive tape for semiconductor device production exhibits better chip component holdability.

The block B may contain a structure derived from a monomer other than the conjugated diene monomer or the (meth)acrylic monomer as long as the effect of the present invention is not impaired.

Examples of the conjugated diene monomer include 1,3-butadiene, isoprene, 2,3-dimethyl-1,3-butadiene, 1,3-pentadiene, 2-methyl-1,3-octadiene, 1,3-hexadiene, 1,3-cyclohexadiene, 4,5-diethyl-1,3-octadiene, 3-butyl-1,3-octadiene, myrcene, and chloroprene. These conjugated diene monomers may be used alone, or two or more thereof may be used in combination. Preferred among these are 1,3-butadiene and isoprene because of their high polymerization reactivity and industrial availability.

In the structure derived from a conjugated diene monomer, the double bond (unsaturated bond) may be converted to a saturated bond by hydrogenation. For example, when the double bond (unsaturated bond) of the structure derived from 1,3-butadiene as the structure derived from the conjugated diene monomer is hydrogenated, the structure is converted to an ethylene-butylene structure. The degree of the hydrogenation (hydrogenation degree) is not limited. The double bond may be partially hydrogenated or mostly hydrogenated.

The degree of hydrogenation (hydrogenation degree) can be calculated by measuring the $^{1}$H-NMR spectrum at 20 Hz using deuterated chloroform as a solvent.

In the ABA block copolymer, the amount of the structure derived from a conjugated diene monomer is not limited as long as the effect of the present invention is exerted. The amount is preferably 0% by weight or more and 99% by weight or less. The amount of the structure derived from a conjugated diene monomer is more preferably 30% by weight or more, still more preferably 40% by weight or more, even more preferably 70% by weight or more, furthermore preferably 80% by weight or more. The amount of the structure derived from a conjugated diene monomer is more preferably 95% by weight or less, still more preferably 90% by weight or less.

The amount of the structure derived from a conjugated diene monomer is more preferably 70% by weight or more and 95% by weight or less, still more preferably 80% by weight or more and 90% by weight or less.

The (meth)acrylic monomer used may include one monomer or multiple monomers. The structure derived from a (meth)acrylic monomer herein refers to a structure represented by the following formula (5) or (6).

[Chem. 2]

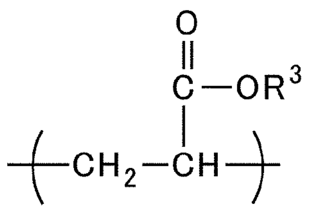
(5)

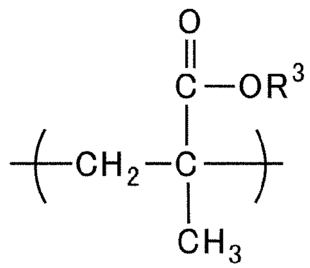
(6)

In the formulas (5) and (6), $R^3$ represents a side chain. Examples of the side chain $R^3$ include methyl, ethyl, propyl, butyl, isobutyl, pentyl, hexyl, cyclohexyl, heptyl, octyl, isooctyl, 2-ethylhexyl, nonyl, isononyl, decyl, lauryl, stearyl, isostearyl, and isobornyl groups.

Examples of the (meth)acrylic monomer include methyl (meth)acrylate, ethyl (meth)acrylate, propyl (meth)acrylate, butyl (meth)acrylate, isobutyl (meth)acrylate, pentyl (meth)acrylate, hexyl (meth)acrylate, cyclohexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, lauryl (meth)acrylate, stearyl (meth)acrylate, isostearyl (meth)acrylate, and isobornyl (meth)acrylate. These (meth)acrylic monomers may be used alone, or two or more thereof may be used in combination. Preferred among these are butyl (meth)acrylate, 2-ethylhexyl (meth)acrylate, and lauryl (meth)acrylate in order to balance the chip component separability and the effect of reducing adhesive deposits on the chip components. In order to further reduce adhesive deposits on the chip components, more preferred are butyl (meth)acrylate and 2-ethylhexyl (meth)acrylate. Still more preferred are these acrylates.

The glass transition temperature of the block B in the ABA block copolymer is not limited and is preferably -30°C or higher and 0°C or lower. By setting the glass transition temperature of the block B within the above range, the adhesive tape can exhibit improved chip component separability and adhesive deposits on the chip components can be further reduced even in the case where chip components having protrusions or small-sized chip components are transferred. The lower limit of the glass transition temperature of the block B is more preferably - 28°C, still more preferably -25°C, and the upper limit thereof is more preferably -5°C, still more preferably - 10°C.

The glass transition temperature of the block B can be determined by measurement using, for example, a differential scanning calorimeter (products of TA Instruments, Hitachi High-Tech Science, etc.). More specifically, the measurement is performed on the ABA block copolymer using a differential scanning calorimeter (SII Exstar 6000/DSC 6220, available from Hitachi High-Tech Science) in a nitrogen atmosphere at a heating rate of 10°C/min. The value obtained in the second run can be used. In the measurement, a peak derived from the block A and a peak derived from

the block B are obtained. The peak on the low temperature side is taken as the peak derived from the block B, and the glass transition temperature of the block B is determined.

The glass transition temperature of the block B may be adjusted to the above range by any method. In order to adjust the glass transition temperature of the block B to the above range, the (meth)acrylic monomer preferably contains a (meth)acrylic acid ester monomer that has a glass transition temperature of 0°C or higher when formed into a homopolymer.

When the (meth)acrylic monomer contains a (meth)acrylic acid ester monomer that has a glass transition temperature of 0°C or higher when formed into a homopolymer, the storage modulus of the first adhesive layer can be adjusted to a more preferred range. Examples of the (meth)acrylic acid ester monomer that has a glass transition temperature of 0°C or higher when formed into a homopolymer include methyl acrylate, methyl methacrylate, ethyl methacrylate, normal butyl methacrylate, isobutyl methacrylate, tertiary butyl acrylate, tertiary butyl methacrylate, cyclohexyl acrylate, cyclohexyl methacrylate, isobornyl acrylate, isobornyl methacrylate, and benzyl methacrylate. Preferred are methyl acrylate and methyl methacrylate.

In the ABA block copolymer, the amount of the structure derived from a (meth)acrylic acid ester monomer that has a glass transition temperature of 0°C or higher when formed into a homopolymer is not limited and may be 0% by weight. Still, the lower limit of the amount is preferably 35% by weight. When the amount of the structure derived from a (meth)acrylic acid ester monomer that has a glass transition temperature of 0°C or higher when formed into a homopolymer is 35% by weight or more, the adhesive tape can exhibit improved chip component separability. The lower limit of the amount of the structure derived from a (meth)acrylic acid ester monomer that has a glass transition temperature of 0°C or higher when formed into a homopolymer is more preferably 40% by weight.

The upper limit of the amount of the structure derived from a (meth)acrylic acid ester monomer that has a glass transition temperature of 0°C or higher when formed into a homopolymer is not limited. In order to temporarily fix chip components, the upper limit of the amount is preferably 60% by weight, more preferably 50% by weight.

The block B preferably further contains a structure derived from a crosslinkable functional group-containing monomer.

When the block B contains the structure derived from a crosslinkable functional group-containing monomer, the cohesive force of the first adhesive layer is increased by crosslinking of the crosslinkable functional group, which can improve the chip component separability of the adhesive tape for semiconductor device production and can reduce adhesive deposits on the chip components. The crosslinkable functional group may or may not be crosslinked and is preferably crosslinked. However, even when the crosslinkable functional group remains uncrosslinked, the interaction between functional groups increases the cohesive force of the first adhesive layer, which can improve the chip component separability of the adhesive tape for semiconductor device production and can reduce adhesive deposits on the chip components. The structure derived from a crosslinkable functional group-containing monomer herein refers to a structure represented by the following formula (3) or (4).

[Chem. 3]

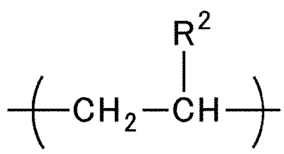 (3) 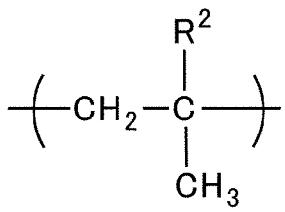 (4)

In the formulas (3) and (4), $R^2$ represents a substituent containing at least one crosslinkable functional group. Examples of the crosslinkable functional group include a carboxy group, a hydroxy group, an epoxy group, a double bond, a triple bond, an amino group, an amide group, and a nitrile group. The substituent $R^2$ containing at least one crosslinkable functional group may contain, as its constituent element, an alkyl group, an ether group, a carbonyl group, an ester group, a carbonate group, an amide group, a urethane groups, or the like.

The crosslinkable functional group-containing monomer is not limited, and examples thereof include a carboxy group-containing monomer, a hydroxy group-containing monomer, an epoxy group-containing monomer, a double bond-containing monomer, a triple bond-containing monomer, an amino group-containing monomer, an amide group-containing monomer, and a nitrile group-containing monomer. These crosslinkable functional group-containing monomers may be used alone, or two or more thereof may be used in combination. Preferred among these is at least one selected from the group consisting of a carboxy group-containing monomer, a hydroxy group-containing monomer, an epoxy group-containing monomer, a double bond-containing monomer, a triple bond-containing monomer, and an amide group-containing monomer because the adhesive tape for semiconductor device production can exhibit improved chip component separability and adhesive deposits on the chip components can be further reduced.

Examples of the carboxy group-containing monomer include a (meth)acrylic acid-based monomer such as (meth)acrylic acid. Examples of the hydroxy group-containing monomer include hydroxyalkyl acrylates and hydroxyalkyl methacrylates such as 4-hydroxybutyl (meth)acrylate and 2-hydroxyethyl (meth)acrylate. Examples of the epoxy group-containing monomer include glycidyl (meth)acrylate. Examples of the double bond-containing monomer include allyl (meth)acrylate and hexanediol di(meth)acrylate. Examples of the triple bond-containing monomer include propargyl (meth)acrylate. Examples of the amide group-containing monomer include (meth)acrylamide. Preferred among these are a carboxy group-containing monomer and a hydroxy group-containing monomer because the adhesive tape for semiconductor device production can exhibit improved chip component separability and adhesive deposits on the chip components can be further reduced. More preferred are a (meth)acrylic acid-based monomer and a hydroxyalkyl acrylate, and still more preferred are acrylic acid, 2-hydroxyethyl acrylate and 4-hydroxybutyl acrylate.

In addition to the block B, the block A also preferably contains the structure derived from a crosslinkable functional group-containing monomer.

The amount of the structure derived from a crosslinkable functional group-containing monomer (the sum of the amount in the block A and the amount in the block B) in the ABA block copolymer is not limited and is preferably 0.1% by weight or more and 30% by weight or less. When the amount of the structure derived from a crosslinkable functional group-containing monomer is within the above range, the cohesive force of the first adhesive layer is further increased, which can further improve the chip component separability of the adhesive tape for semiconductor device production and can further reduce adhesive deposits on the chip components. The lower limit of the amount of the structure derived from a crosslinkable functional group-containing monomer is more preferably 0.5% by weight, still more preferably 1% by weight, and the upper limit thereof is more preferably 25% by weight, still more preferably 20% by weight.

The amount of the block A (hard segment) in the ABA block copolymer is not limited and is preferably 1% by weight or more and 40% by weight or less. When the amount of the block A is within the above range, the breaking strength of the first adhesive layer is increased, which can further reduce adhesive deposits on the chip components. The lower limit of the amount of the block A is more preferably 2% by weight, still more preferably 5% by weight, particularly preferably 10% by weight. The upper limit of the amount of the block A is more preferably 35% by weight, still more preferably 30% by weight, even more preferably 25% by weight, furthermore preferably 22% by weight, particularly preferably 20% by weight.

The weight average molecular weight (Mw) of the ABA block copolymer is not limited and is preferably 50,000 or more and 800,000 or less. When the weight average molecular weight is within the above range, the properties of the first adhesive layer, such as the breaking strength, the storage modulus G', and the gel fraction, can be easily adjusted to the ranges described later, which can further improve the chip component separability of the adhesive tape for semiconductor device production and can further reduce adhesive deposits on the chip components. The lower limit of the weight average molecular weight is more preferably 75,000, still more preferably 100,000, even more preferably 200,000. The upper limit of the weight average molecular weight is more preferably 600,000.

The weight average molecular weight can be determined in terms of standard polystyrene by gel permeation chromatography (GPC), for example. More specifically, the weight average molecular weight can be measured using, for example, "2690 Separations Module" available from Waters as a measuring instrument, "GPC KF-806L" available from Showa Denko K. K. as a column, and ethyl acetate as a solvent, under the conditions of a sample flow rate of 1 mL/min and a column temperature of 40°C.

The SP value of the ABA block copolymer is not limited and is preferably 10 or less. When the SP value is 10 or less, close contact of the first adhesive layer to chip components can be suppressed, which can further improve the separability. The SP value is more preferably 9.98 or less, still more preferably 9.95 or less. The lower limit of the SP value is not limited. The practical lower limit is approximately 8 because synthesis becomes difficult.

The SP value is called a solubility parameter and is a parameter used as an index of polarity. Herein, the Fedors method (R. F. Fedors, Polym. Eng. Sci., 14(2), 147-154 (1974)) is used for calculating the SP value. The SP value of the ABA block copolymer can be calculated based on the SP values of respective repeating units in the copolymer and the compounding ratio (molar ratio) of the repeating units.

In order to obtain the ABA block copolymer, the raw material monomers for the block A and the block B are radically reacted separately in the presence of a polymerization initiator to obtain the block A and the block B, followed by reaction or copolymerization of the two. Alternatively, after the block A is obtained, the raw material monomer for the block B may be added for copolymerization.

A radical reaction method, that is, a polymerization method, may be a conventionally known method such as solution polymerization (boiling point polymerization or constant temperature polymerization), emulsion polymerization, suspension polymerization, or bulk polymerization.

The acrylic copolymer as the base polymer contained in the first adhesive layer is a copolymer having a structure derived from a (meth)acrylic monomer.

Examples of the (meth)acrylic monomer include the same monomers as the (meth)acrylic monomers for the

ABA block copolymer described above. Preferred among these are butyl (meth)acrylate and 2-ethylhexyl (meth)acrylate, and more preferred are butyl acrylate and 2-ethylhexyl acrylate in order to balance the chip component separability and the effect of reducing adhesive deposits on the chip components.

The acrylic copolymer preferably further contains a structure derived from a crosslinkable functional group-containing monomer.

When the acrylic copolymer contains the structure derived from a crosslinkable functional group-containing monomer, the cohesive force of the first adhesive layer is increased by crosslinking of the crosslinkable functional group, which can improve the chip component separability of the adhesive tape for semiconductor device production and can reduce adhesive deposits on the chip components. The crosslinkable functional group may or may not be crosslinked and is preferably crosslinked. However, even when the crosslinkable functional group remains uncrosslinked, the interaction between functional groups increases the cohesive force of the first adhesive layer, which can improve the chip component separability of the adhesive tape for semiconductor device production and can reduce adhesive deposits on the chip components.

Examples of the crosslinkable functional group-containing monomer include the same monomers as the crosslinkable functional group-containing monomers for the ABA block copolymer described above.

The amount of the structure derived from a crosslinkable functional group-containing monomer in the acrylic copolymer is not limited and is preferably 0.1% by weight or more and 30% by weight or less. When the amount of the structure derived from a crosslinkable functional group-containing monomer is within the above range, the cohesive force of the first adhesive layer is further increased, which can further improve the chip component separability of the adhesive tape for semiconductor device production and can further reduce adhesive deposits on the chip components. The lower limit of the amount of the structure derived from the crosslinkable functional group-containing monomer is more preferably 0.5% by weight, still more preferably 1% by weight, and the upper limit thereof is more preferably 25% by weight, still more preferably 20% by weight.

The weight average molecular weight (Mw) of the acrylic copolymer is not limited and is preferably 200,000 or more and 2,000,000 or less. When the weight average molecular weight is within the above range, the properties of the first adhesive layer, such as the breaking strength, the storage modulus G’, and the gel fraction, can be easily adjusted to the ranges described later, which can further improve the chip component separability of the adhesive tape for semiconductor device production and can further reduce adhesive deposits on the chip components. The lower limit of the weight average molecular weight is more preferably 400,000 and the upper limit thereof is more preferably 1,500,000.

The SP value of the acrylic copolymer is not limited and is preferably 10 or less. When the SP value is 10 or less, close contact of the first adhesive layer to chip components can be suppressed, which can further improve the separability. The SP value is more preferably 9.98 or less, still more preferably 9.95 or less. The lower limit of the SP value is not limited. The practical lower limit is approximately 8 because synthesis becomes difficult.

The SP value is called a solubility parameter and is a parameter used as an index of polarity. Herein, the Fedors method (R. F. Fedors, Polym. Eng. Sci., 14(2), 147-154 (1974)) is used for calculating the SP value. The SP value of the acrylic copolymer can be calculated based on the SP values of respective repeating units in the copolymer and the compounding ratio (molar ratio) of the repeating units.

The first adhesive layer preferably further contains a crosslinking agent.

The crosslinking agent is not limited and is selected according to the type of the crosslinkable functional group in the base polymer contained in the first adhesive layer. Examples thereof include an isocyanate crosslinking agent, an epoxy crosslinking agent, an aziridine crosslinking agent, and a metal chelate crosslinking agent. More specifically, for example, when the crosslinkable functional group in the base polymer contained in the first adhesive layer is a carboxy group, examples of the crosslinking agent include an epoxy crosslinking agent, an isocyanate crosslinking agent, and a metal chelate crosslinking agent.

Preferred among these are an epoxy crosslinking agent and an isocyanate crosslinking agent because the properties of the first adhesive layer, such as the breaking strength, the storage modulus G’, and the gel fraction, can be easily adjusted within the ranges described later.

The amount of the crosslinking agent is not limited. The degree of crosslinking (gel fraction) of the first adhesive layer can be adjusted by adjusting the amount of the crosslinkable functional group in the base polymer contained in the first adhesive layer and the amount of the crosslinking agent.

The amount of the crosslinking agent is preferably 0.01 parts by weight or more and 10 parts by weight or less relative to 100 parts by weight of the base polymer contained in the first adhesive layer. When the amount of the crosslinking agent is within the above range, the base polymer contained in the first adhesive layer can be appropriately crosslinked to increase the cohesive force of the first adhesive layer, which can further improve the chip component separability of the adhesive tape for semiconductor device production and can further reduce adhesive deposits on the chip components. The lower limit of the amount of the crosslinking agent is more preferably 0.1 parts by weight and the upper limit thereof is more preferably 5 parts by weigh. The lower limit is still more preferably 0.15 parts by weight and the upper limit is still more preferably 3 parts by weight.

The first adhesive layer may further contain a tackifier (tackiness imparting agent).

The tackifier may be a tackifier that is solid at normal temperature or a tackifier that is liquid at normal temperature. The "normal temperature" herein means 20°C to 25°C, and the term "liquid" means having fluidity.

Any tackifier may be used. Examples thereof include a rosin ester resin, a terpene phenol resin, a terpene resin, and a coumarone resin.

The amount of the tackifier is not limited. Preferably, the first adhesive layer does not contain a tackifier from the standpoint of chip component separability of the adhesive tape for semiconductor device production. In the case where the tackifier is contained, the amount thereof is preferably 10 parts by weight or less relative to 100 parts by weight of the base polymer contained in the first adhesive layer. When the amount of the tackifier is within the above range, the adhesive tape for semiconductor device production can exhibit improved chip component separability. The upper limit of the amount of the tackifier is more preferably 5 parts by weight.

The first adhesive layer may further contain the same UV absorber as the UV absorber contained in the ablation layer, as long as the effect of the present invention is not impaired. The UV absorbance of the first adhesive layer may be, but not limited to, approximately the same as that of the ablation layer.

The first adhesive layer may further contain an inorganic filler such as fumed silica.

Compounding the inorganic filler can increase the cohesive force of the first adhesive layer, which can further improve the chip component separability of the adhesive tape for semiconductor device production and can further reduce adhesive deposits on the chip components.

The first adhesive layer may further contain known additives such as a plasticizer, a resin, a surfactant, a wax, and a fine particle filler. These additives may be used alone, or two or more thereof may be used in combination.

The first adhesive layer may have any breaking strength. The lower limit of the breaking strength is preferably 1 MPa. When the breaking strength is 1 MPa or more, the first adhesive layer is further less likely to be torn off upon separation of the chip components by laser abrasion, which can further reduce adhesive deposits on the chip components. The lower limit of the breaking strength is more preferably 1.3 MPa, still more preferably 1.4 MPa.

The upper limit of the breaking strength is not limited. Since too high a breaking strength lowers the chip component separability of the adhesive tape for semiconductor device production, the upper limit thereof is preferably 10 MPa, more preferably 8 MPa, still more preferably 7 MPa, furthermore preferably 6 MPa.

The breaking strength of the first adhesive layer can be calculated, for example, from the stress at break when the adhesive layer is pulled at a tensile speed of 500 mm/min in an environment at a temperature of 23°C and a relative humidity of 50% in conformity with JIS K7161: 2014 using a device such as Autograph (available from Shimadzu Corporation). For the measurement of the breaking strength, a sample consisting only of the first adhesive layer is prepared by removing the layers other than the first adhesive layer, such as the substrate, from the adhesive tape. The substrate and other layers may be removed by any method that does not include treatment using a solvent, treatment involving chemical reaction, treatment at high temperature, and the like in order to avoid modification of the first adhesive layer. Examples of a specific method include a method in which the first adhesive layers are bonded to each other, and the layers are peeled off at a temperature and a speed each selected appropriately so that the substrate and other layers are separated and removed from the bonded first adhesive layers, and a method in which the substrate and other layers are physically ground.

When the thickness of the first adhesive layer is less than 100 μm, the first adhesive layers are stacked to form an adhesive layer for measurement having a thickness of 100 um or more. The breaking strength of the obtained adhesive layer for measurement is measured as described above.

The first adhesive layer may have any storage modulus (shear storage modulus) G' at 23°C and 1 Hz. The lower limit of the storage modulus G' at 23°C and 1 Hz is preferably $1 \times 10^4$ Pa and the upper limit thereof is preferably $2 \times 10^6$ Pa. When the storage modulus G' is $1 \times 10^4$ Pa or more, the adhesive tape for semiconductor device production can exhibit improved chip component separability. When the storage modulus G' is $2 \times 10^6$ Pa or less, the adhesive tape for semiconductor device production can exhibit improved chip component holdability. The lower limit of the storage modulus G' is more preferably $2 \times 10^4$ Pa and the upper limit thereof is more preferably $1.5 \times 10^6$ Pa. The lower limit is still more preferably $3 \times 10^4$ Pa and the upper limit is still more preferably $1.2 \times 10^6$ Pa.

The storage modulus G' of the first adhesive layer at 23°C and 1 Hz can be determined as a storage modulus at 23°C in measurement of a dynamic viscoelasticity spectrum from -40°C to 140°C under the conditions of 1 Hz in a simple heating mode of a heating rate of 5°C/min using a viscoelastic spectrometer (DVA-200, available from IT Keisoku Seigyo Co., Ltd., or its equivalent product), for example.

When the thickness of the first adhesive layer is less than 100 μm, the first adhesive layers are stacked to form an adhesive layer for measurement having a thickness of 100 um or more. The storage modulus G' of the obtained adhesive layer for measurement is measured as described above.

The first adhesive layer may have any storage modulus (shear storage modulus) G' at -20°C and 1 Hz. The lower limit of the storage modulus G' at -20°C and 1 Hz is preferably $3 \times 10^5$ Pa and the upper limit thereof is preferably $1 \times 10^8$ Pa. When the storage modulus G' is $3 \times 10^5$ Pa or more, the adhesive tape for semiconductor device production

can exhibit improved chip component separability. When the storage modulus G' is $1 \times 10^8$ Pa or less, the adhesive tape for semiconductor device can exhibit improved chip component holdability. The lower limit of the storage modulus G' is more preferably $5 \times 10^6$ Pa and the upper limit is more preferably $5 \times 10^7$ Pa. The lower limit is still more preferably $1 \times 10^7$ Pa and the upper limit is still more preferably $3 \times 10^7$ Pa.

The first adhesive layer may have any storage modulus (shear storage modulus) G' at 140°C and 1 Hz. The lower limit of the storage modulus G' at 140°C and 1 Hz is preferably $3 \times 10^4$ Pa and the upper limit thereof is preferably $3 \times 10^5$ Pa. When the storage modulus G' is $3 \times 10^4$ Pa or more, the adhesive tape for semiconductor device production can exhibit improved chip component separability even in the case of transfer of chip components having protrusions or small-sized chip components. When the storage modulus G' is $3 \times 10^5$ Pa or less, the adhesive tape for semiconductor device production can exhibit improved chip component holdability even in the case of transfer of chip components having protrusions or small-sized chip components. The lower limit of the storage modulus G' is more preferably $5 \times 10^4$ Pa and the upper limit thereof is more preferably $2.5 \times 10^5$ Pa. The lower limit is still more preferably $9 \times 10^4$ Pa and the upper limit is still more preferably $2 \times 10^5$ Pa.

The storage moduli G' of the first adhesive layer at -20°C and 1 Hz and at 140°C and 1 Hz can be determined as storage moduli at -20°C and 140°C in measurement of a dynamic viscoelasticity spectrum from -40°C to 160°C under the conditions of 1 Hz in a simple heating mode of a heating rate of 5°C/min using a viscoelastic spectrometer (DVA-200, available from IT Keisoku Seigyo Co., Ltd., or its equivalent product), for example.

When the thickness of the first adhesive layer is less than 100 μm, the first adhesive layers are stacked to form an adhesive layer for measurement having a thickness of 100 um or more. The storage modulus G' of the obtained adhesive layer for measurement is measured as described above.

The first adhesive layer may have any gel fraction. The lower limit of the gel fraction is preferably 70% by weight and the upper limit thereof is preferably 95% by weight. When the gel fraction is 70% by weight or more, the adhesive tape for semiconductor device production exhibits better chip component separability. When the gel fraction is 95% by weight or less, the adhesive tape for semiconductor device production exhibits better chip component holdability. The lower limit of the gel fraction is more preferably 80% by weight and the upper limit thereof is more preferably 90% by weight.

The gel fraction of the first adhesive layer can be measured by the following method.

The first adhesive layer (adhesive composition) alone in an amount of 0.1 g is taken out from the adhesive tape for semiconductor device production, immersed in 50 mL of ethyl acetate, and shaken using a shaker under the conditions of a temperature of 23°C and 200 rpm for 24 hours. After the shaking, a metal mesh (#200 mesh) is used to separate ethyl acetate and the adhesive composition that has been swollen by absorbing ethyl acetate. The separated adhesive composition is dried under the condition of 110°C for one hour. The weight of the adhesive composition including the metal mesh after drying is measured, and the gel fraction of the first adhesive layer is calculated using the following equation.

$$\text{Gel fraction (\% by weight)} = 100 \times (W_1 - W_2)/W_0$$

($W_0$: the initial weight of the adhesive composition, $W_1$: the weight of the adhesive composition including the metal mesh after drying, $W_2$: the initial weight of the metal mesh)

When the first adhesive composition is not completely dissolved in ethyl acetate, a solvent such as toluene, hexane, or water is used instead of ethyl acetate. Specifically, when the first adhesive composition contains a styrene elastomer, for example, toluene or hexane is used. When the first adhesive composition contains polyvinyl alcohol, hot water at 90°C is used.

The properties of the first adhesive layer, such as the breaking strength, the storage modulus G', and the gel fraction, may be adjusted to the above ranges by any methods. In an exemplary method, the composition or weight average molecular weight (Mw) of the base polymer contained in the first adhesive layer and the type or amount of the crosslinking agent are adjusted as described above.

The first adhesive layer may have any phase separation structure, and preferably has a spherical phase separation structure. When the first adhesive layer has a spherical phase separation structure, the properties of the first adhesive layer, such as the storage modulus, the breaking strength, and the gel fraction, are easily adjusted to the above ranges, which further improves the chip component separability of the adhesive tape for semiconductor device production and further reduces adhesive deposits on the chip components. The phase separation structure of the first adhesive layer can be controlled, for example, by adjusting the ratio of blocks in the ABA block copolymer.

The first adhesive layer may have a cylindrical phase separation structure. When the first adhesive layer has a cylindrical phase separation structure, the properties of the first adhesive layer, such as the storage modulus, the breaking strength, and the gel fraction, are easily adjusted to the above ranges, which further improves the chip component separability of the adhesive tape and further reduces adhesive deposits on the chip components. In particular, when the first adhesive layer has a cylindrical phase separation structure, the properties of the first adhesive layer, such as the

storage modulus and the breaking strength, can be easily adjusted to relatively large ranges, which further improves the chip component separability of the adhesive tape and further reduces adhesive deposits on the chip components even in the case of transfer of chip components having protrusions or small-sized chip components.

The phase separation structure of the adhesive layer can be confirmed by observation with a transmission electron microscope (TEM). The term "spherical" means that the micro phase separation structure is an orbicular structure and the term "cylindrical" means that the micro phase separation structure is a circular cylindrical structure.

When the first adhesive layer has a spherical phase separation structure, the island structure in the spherical phase separation structure may have any size. The lower limit of the average major diameter of the island structure is preferably 5 nm and the upper limit thereof is preferably 100 nm. The lower limit is more preferably 10 nm and the upper limit more preferably 50 nm. When the average major diameter is within the above range, the adhesive tape can exhibit improved chip component separability and adhesive deposits on the chip components can be further reduced.

The average major diameter of the island structure in the spherical phase separation structure can be measured by the following method.

The first adhesive layer is observed with a transmission electron microscope (TEM) at a magnification of 5,000 times to obtain an observation image of an area of 4.3 um $\times$ 4.3 um. The obtained image is automatically binarized using image analysis software (e.g., Avizo, ver. 2019.4, available from Thermo Fisher Scientific). The major diameters of the island structures (dark areas) in the binarized image are measured, and the arithmetic mean value of these is taken as the average major diameter. The details of the automatic binarization method are based on a known literature ("An Automatic Threshold Selection Method. Based on Discriminant and Least Squares Criteria.", Nobuyuki Otsu, The IEICE transactions on information and systems, Vol. J63-D, No. 4, pp. 349-356).

The first adhesive layer may have any thickness. The lower limit of the thickness is preferably 3 um and the upper limit thereof is preferably 50 μm. When the thickness of the first adhesive layer is 3 um or more, the adhesive tape for semiconductor device production can exhibit improved chip component holdability and better chip component separability. When the thickness of the first adhesive layer is 50 um or less, adhesive deposits on chip components can be further reduced. In order to further improve the chip component holdability and the chip component separability of the adhesive tape for semiconductor device production and to further reduce adhesive deposits on the chip components, the lower limit of the thickness of the first adhesive layer is more preferably 5 um and the upper limit thereof is more preferably 30 um. The lower limit is still more preferably 8 um and the upper limit is still more preferably 20 μm.

The adhesive tape for semiconductor device production of the present invention may include a second adhesive layer on the side of the substrate opposite to the side on which the ablation layer, the barrier layer, and the first adhesive layer are laminated in this order.

In other words, the adhesive tape for semiconductor device production of the present invention may further include a second adhesive layer, and includes the second adhesive layer, the substrate, the ablation layer, the barrier layer, and the first adhesive layer in this order. Including the second adhesive layer, the adhesive tape for semiconductor device production of the present invention can be easily bonded to a glass support or the like.

FIG. 4 shows a cross-sectional view schematically illustrating an example of the adhesive tape for semiconductor device production of the present invention including the second adhesive layer. In an adhesive tape 12 for semiconductor device production of the present invention shown in FIG. 4, a second adhesive layer 4b, a substrate 5, an ablation layer 10, a barrier layer 11, and a first adhesive layer 4a are laminated in this order.

The second adhesive layer is preferably, but not limited to, a pressure-sensitive adhesive layer.

Examples of a base polymer contained in the second adhesive layer include an ABA block copolymer, an acrylic copolymer, a urethane copolymer, and a silicone adhesive. Preferred among these are an ABA block copolymer and an acrylic copolymer because they allow the second adhesive layer to strongly adhere to a support such as a glass substrate and to be removed without adhesive deposits.

The ABA block copolymer as the base polymer contained in the second adhesive layer may be the same polymer as the ABA block copolymer used in the first adhesive layer described above.

The second adhesive layer may have any phase separation structure, and preferably has a spherical phase separation structure because the adhesive tape can readily have both strong adhesiveness and removability.

The ABA block copolymer may include any block B that has a flexible structure. Still, the block B preferably contains a structure derived from a (meth)acrylic monomer, more preferably contains butyl acrylate or 2-ethylhexyl acrylate.

The acrylic copolymer as the base polymer contained in the second adhesive layer may be the same polymer as the acrylic copolymer used in the first adhesive layer.

The acrylic copolymer as the base polymer contained in the second adhesive layer is a copolymer having a structure derived from a (meth)acrylic monomer.

Examples of the (meth)acrylic monomer include the same monomers as the (meth)acrylic monomers for the ABA block copolymer described above. Preferred among these are butyl acrylate and 2-ethylhexyl acrylate because the adhesive tape can readily have both strong adhesiveness and removability.

The acrylic copolymer preferably further contains a structure derived from a crosslinkable functional group-containing monomer from the standpoint of removal of the second adhesive layer without adhesive deposits.

Examples of the crosslinkable functional group-containing monomer include the same monomers as the crosslinkable functional group-containing monomers for the ABA block copolymer described above.

The amount of the structure derived from a crosslinkable functional group-containing monomer in the acrylic copolymer is not limited and is preferably 0.1% by weight or more and 30% by weight or less. When the amount of the structure derived from a crosslinkable functional group-containing monomer is within the above range, the adhesive tape can have both strong adhesiveness and removability. The lower limit of the amount of the structure derived from a crosslinkable functional group-containing monomer is more preferably 0.5% by weight, still more preferably 1% by weight, and the upper limit thereof is more preferably 25% by weight, still more preferably 20% by weight.

The weight average molecular weight (Mw) of the acrylic copolymer is not limited and is preferably 200,000 or more and 2,000,000 or less. When the weight average molecular weight is within the above range, the adhesive tape can have both strong adhesiveness and removability. The lower limit of the weight average molecular weight is more preferably 400,000 and the upper limit thereof is more preferably 1,500,000.

The second adhesive layer preferably contains a crosslinking agent.

The crosslinking agent is not limited and is selected according to the type of the crosslinkable functional group in the base polymer contained in the second adhesive layer. Examples thereof include an isocyanate crosslinking agent, an epoxy crosslinking agent, an aziridine crosslinking agent, and a metal chelate crosslinking agent. More specifically, when the crosslinkable functional group in the base polymer contained in the second adhesive layer is a carboxy group, the crosslinking agent may be, for example, an epoxy crosslinking agent, an isocyanate crosslinking agent, or a metal chelate crosslinking agent.

Preferred among these are an epoxy crosslinking agent and an isocyanate crosslinking agent from the standpoint of achievement of both strong adhesiveness and removability.

The amount of the crosslinking agent is not limited. The degree of crosslinking (gel fraction) of the second adhesive layer can be adjusted by adjusting the amount of the crosslinkable functional group in the base polymer contained in the second adhesive layer and the amount of the crosslinking agent.

The amount of the crosslinking agent is preferably 0.01 parts by weight or more and 10 parts by weight or less relative to 100 parts by weight of the base polymer contained in the second adhesive layer. When the amount of the crosslinking agent is within the above range, the adhesive tape can achieve both strong adhesiveness and removability. The lower limit of the amount of the crosslinking agent is more preferably 0.1 parts by weight and the upper limit thereof is more preferably 5 parts by weight. The lower limit is still more preferably 0.15 parts by weight and the upper limit is still more preferably 3 parts by weight.

The second adhesive layer may further contain a tackifier (tackiness imparting agent).

Any tackifier may be used. Preferably, the tackifier has an appropriate UV transmittance. The tackifier may have any UV transmittance. The lower limit of the UV transmittance at a wavelength of 365 nm is preferably 1%, more preferably 50%, still more preferably 80%. The upper limit of the UV transmittance at a wavelength of 365 nm is not limited. The practical upper limit is approximately 95%. A hydrogenated tackifier is preferred because such a tackifier has a high UV transmittance.

Any tackifier may be used. Examples of the tackifier include a rosin ester resin, a terpene phenol resin, a terpene resin, and a coumarone resin. Preferred are a hydrogenated rosin ester, a hydrogenated terpene phenol, and a hydrogenated terpene resin.

The amount of the tackifier is not limited. Preferably, the second adhesive layer does not contain a tackifier from the standpoint of removability. In the case where the tackifier is contained, the amount thereof is preferably 10 parts by weight or less relative to 100 parts by weight of the base polymer contained in the second adhesive layer. When the amount of the tackifier, which is solid at room temperature, is within the above range, adhesive deposits are not likely to be generated upon removal of the second adhesive layer. The lower limit of the amount of the tackifier is more preferably 5 parts by weight and the upper limit thereof is more preferably 3 parts by weight.

The second adhesive layer preferably has an appropriate UV transmittance. The UV transmittance is not limited. The lower limit of the UV transmittance at a wavelength of 365 nm is preferably 1%, more preferably 50%, still more preferably 80%. The upper limit of the UV transmittance at a wavelength of 365 nm is not limited. The practical upper limit is approximately 95%.

The second adhesive layer may further contain an inorganic filler such as fumed silica.

Compounding the inorganic filler improves the cohesive force of the second adhesive, which facilitates achievement of both strong adhesiveness and removability.

The second adhesive layer may further contain known additives such as a plasticizer, a resin, a surfactant, a wax, or a fine particle filler. These additives may be used alone, or two or more thereof may be used in combination.

The second adhesive layer may have any adhesion. The lower limit of the adhesion is preferably 0.8 N/25 mm. When the adhesion is 0.8 N/25 mm or more, detachment of the tape from a support such as a glass substrate upon

separation of chip components can be avoided. The lower limit of the adhesion is more preferably 2 N/25 mm, still more preferably 6 N/25 mm, even more preferably 12 N/25 mm.

The upper limit of the adhesion is not limited. From the standpoint of removability, the upper limit is preferably 20 N/25 mm, more preferably 18 N/25 mm, still more preferably 16 N/25 mm.

The adhesion of the second adhesive layer can be measured, for example, in conformity with JIS Z0237: 2009 using a device such as Autograph (available from Shimadzu Corporation). Specifically, an adhesive tape is cut to a width of 25 mm, and bonded to a glass plate at a speed of 300 mm/min using a 2-kg pressure rubber roller at a room temperature of 23°C and a relative humidity of 50%, followed by standing for 30 minutes. The adhesive tape is then peeled off at a speed of 300 mm/min to measure the 180° peel strength.

The second adhesive layer may have any gel fraction. The lower limit of the gel fraction is preferably 30% by weight and the upper limit thereof is preferably 90% by weight. When the gel fraction is 30% by weight or more, adhesive deposits are less likely to be generated upon removal of the adhesive tape. When the gel fraction is 90% by weight or less, the adhesion is easily adjusted high. The lower limit of the gel fraction is more preferably 40% by weight and the upper limit thereof is more preferably 80% by weight.

The gel fraction of the second adhesive layer can be measured by the following method.

The second adhesive layer (adhesive composition) alone in an amount of 0.1 g is taken out from the adhesive tape for semiconductor device production, immersed in 50 mL of ethyl acetate, and shaken using a shaker for 24 hours at a temperature of 23°C and 200 rpm. After the shaking, a metal mesh (#200 mesh) is used to separate ethyl acetate and the adhesive composition that has been swollen by absorbing ethyl acetate. The separated adhesive composition is dried under the condition of 110°C for one hour. The weight of the adhesive composition including the metal mesh after drying is measured, and the gel fraction of the second adhesive layer is calculated using the following equation.

$$\text{Gel fraction (\% by weight)} = 100 \times (W_1 - W_2)/W_0$$

($W_0$: the initial weight of the adhesive composition, $W_1$: the weight of the adhesive composition including the metal mesh after drying, $W_2$: the initial weight of the metal mesh)

When the second adhesive composition is not completely dissolved in ethyl acetate, a solvent such as toluene, hexane, or water is used instead of ethyl acetate. Specifically, when the second adhesive composition contains a styrene-based elastomer, for example, toluene or hexane is used. When the second adhesive composition contains polyvinyl alcohol, for example, hot water at 90°C is used.

The properties of the second adhesive layer, such as the adhesion and the gel fraction, may be adjusted to the above ranges by any methods. In an exemplary method, the composition or weight average molecular weight (Mw) of the base polymer contained in the second adhesive layer and the type or amount of the crosslinking agent are adjusted as described above.

The second adhesive layer may have any thickness. The lower limit of the thickness is preferably 3 um and the upper limit thereof is preferably 30 um. When the thickness of the second adhesive layer is 3 um or more, detachment of the tape from a support such as a glass substrate upon separation of chip components can be avoided. When the thickness of the second adhesive layer is 30 μm or less, the adhesive tape is easily removable. The lower limit of the thickness of the second adhesive layer is more preferably 5 μm and the upper limit thereof is more preferably 20 μm. The lower limit is still more preferably 8 um and the upper limit is still more preferably 12 pm.

The adhesive tape for semiconductor device production of the present invention only needs to include the substrate, the ablation layer, the barrier layer, and the first adhesive layer as described above in this order, and may further include other layers as long as the effect of the present invention is not impaired. When the barrier layer has an easy-adhesion resin layer on the side of the barrier layer in contact with the first adhesive layer, the adhesive tape for semiconductor device production of the present invention only needs to include the substrate, the ablation layer, the barrier layer (having an easy-adhesion resin layer on the side in contact with the first adhesive layer), and the first adhesive layer as described above in this order, and may further include other layers as long as the effect of the present invention is not impaired. In the case of including the second adhesive layer, the adhesive tape for semiconductor device production of the present invention only needs to include the second adhesive layer, the substrate, the ablation layer, the barrier layer, and the first adhesive layer as described above in this order, and may include other layers as long as the effect of the present invention is not impaired.

The first adhesive layer of the adhesive tape for semiconductor device production of the present invention may have any ball tack value. Still, the ball tack value is preferably 5 or higher. With the ball tack value of 5 or higher, the adhesive tape for semiconductor device production can exhibit improved chip component holdability. The ball tack value is more preferably 6 or higher. The upper limit of the ball tack value is not limited. In order to further improve the chip component separability, the ball tack value is preferably 12 or lower.

The ball tack value of the adhesive tape for semiconductor device production can be measured and calculated,

for example, in conformity with JIS Z0237 using a ball tack tester (available from Yasuda Seiki Seisakusho, Ltd.) in an environment of a temperature of 23°C and a relative humidity of 50%.

The first adhesive layer of the adhesive tape for semiconductor device production of the present invention may have any surface peel strength. The upper limit of the surface peel strength is preferably 1 MPa. When the surface peel strength is 1 MPa or less, the adhesive tape for semiconductor device production can exhibit improved chip component separability. The upper limit of the surface peel strength is more preferably 0.8 MPa. The lower limit of the surface peel strength is not limited. In order to further improve the chip component holdability, the lower limit is preferably 0.65 MPa.

The surface peel strength of the first adhesive layer of the adhesive tape for semiconductor device production can be determined, for example, as follows. To the surface of the first adhesive layer of the adhesive tape for semiconductor device production is bonded one face of a SUS cube with 10 mm sides, and pressure-bonded at 0.3 MPa for 10 seconds in an environment of a temperature of 23°C and a relative humidity of 50%. Then, the SUS cube is pulled at a tensile speed of 1,000 mm/min to be separated with the substrate side of the adhesive tape for semiconductor device production fixed, in an environment of a temperature of 23°C and a relative humidity of 50% using a device such as Autograph (available from Shimadzu Corporation). The maximum stress at the time of removal is taken as the surface peel strength.

The adhesive tape for semiconductor device production of the present invention may have any visible light transmittance, and preferably has an appropriate visible light transmittance from the standpoint of separation of chip components by laser ablation. The lower limit of the visible light transmittance is preferably 50%, more preferably 80%. The upper limit of the visible light transmittance is not limited. The practical upper limit is approximately 95%.

The adhesive tape for semiconductor device production of the present invention may have any haze, and preferably has a small haze from the standpoint of separation of chip components by laser ablation. The upper limit of the haze is preferably 10%, more preferably 5%, still more preferably 3%. The lower limit of the haze is not limited and the smaller the better. The practical lower limit is approximately 0.1%.

The visible light transmittance and haze of the adhesive tape for semiconductor device production can be measured using, for example, a haze meter (NDH4000, available from Nippon Denshoku Industries Co., Ltd.).

The adhesive tape for semiconductor device production of the present invention may be used for any application, and is preferably used in the production of semiconductor devices including a step of irradiation with laser light. The adhesive tape for semiconductor device production of the present invention exhibits excellent chip component separability and can reduce adhesive deposits on the chip components, and therefore is more preferably used in the step of separating chip components on the first adhesive layer by laser ablation as illustrated in Fig. 3.

The chip components are not limited, and examples thereof include mini-LED chips, micro-LED chips, optical chips for image sensors. Preferred among these are micro-LED chips.

The chip components may be transferred using the adhesive tape for semiconductor device production of the present invention by any method. An exemplary transferring method includes a step of arranging chip components on the first adhesive layer of the adhesive tape for semiconductor device production of the present invention and a step of separating the chip components by irradiation with laser light. An electronic device component may be produced using the adhesive tape for semiconductor device production of the present invention by any method. Examples of the method include methods for producing electronic device components including the process of transferring chip components as described above. These methods enable transfer of chip components with a high yield and can reduce adhesive deposits on the chip components.

- Advantageous Effects of Invention

The present invention can provide an adhesive tape for semiconductor device production which exhibits excellent chip component separability and can reduce adhesive deposits on chip components.

BRIEF DESCRIPTION OF DRAWINGS

FIG. 1 shows a cross-sectional view schematically illustrating an exemplary step of separating chip components on an adhesive layer by laser ablation using a conventional adhesive tape.

FIG. 2 shows a cross-sectional view schematically illustrating an example of the adhesive tape for semiconductor device production of the present invention.

FIG. 3 shows a cross-sectional view schematically illustrating an example of a step of separating chip components on the first adhesive layer by laser abrasion using the adhesive tape for semiconductor device production of the present invention.

FIG. 4 shows a cross-sectional view schematically illustrating an example of the adhesive tape for semiconductor

device production of the present invention including a second adhesive layer.

DESCRIPTION OF EMBODIMENTS

The embodiments of the present invention will be described in more detail below with reference to, but not limited to, examples.

(Adhesive A)

(1) Preparation of acrylic copolymer (1)

A reactor equipped with a thermometer, a stirrer, and a condenser was charged with 52 parts by weight of ethyl acetate and purged with nitrogen. The reactor was then heated to start reflux. Thirty minutes after the ethyl acetate came to a boil, 0.08 parts by weight of azobisisobutyronitrile as a polymerization initiator was added. Then, a monomer mixture containing 98 parts by weight of butyl acrylate (BA) and 2 parts by weight of acrylic acid (AAc) was dripped into the reactor uniformly and gradually over one and a half hours to perform reaction. Thirty minutes after the dripping was finished, 0.1 parts by weight of azobisisobutyronitrile was added to perform polymerization reaction for another five hours, followed by cooling while adding ethyl acetate into the reactor for dilution. Thus, a solution of an acrylic copolymer (1) having a solid content of 30% by weight was obtained.

The weight average molecular weight of the obtained acrylic copolymer (1) was measured by GPC. The measurement was performed using "2690 Separations Module" available from Waters as a measuring instrument, "GPC KF-806L" available from Showa Denko K. K. as a column, and ethyl acetate as a solvent, under the conditions of a sample flow rate of 1 mL/min and a column temperature of 40°C.

The SP value of the entire polymer of the obtained acrylic copolymer (1) was calculated by the Fedors method.

(2) Preparation of adhesive solution

The obtained acrylic copolymer (1) was dissolved in ethyl acetate so that the solid content was 15% by weight. To 100 parts by weight of the acrylic copolymer (1) were added 3.6 parts by weight of Coronate L (available from Tosoh Corporation) as an isocyanate crosslinking agent and 8 parts by weight of Tinuvin 928 (benzotriazole UV absorber, available from BASF Japan) as an UV absorber, followed by sufficient stirring. Thus, an adhesive solution of an adhesive A was obtained.

(Adhesive B)

(1) Preparation of ABA block copolymer (1)

An autoclave was charged with 500 parts by weight of degassed, dehydrated cyclohexane, 0.13 parts by weight of n-butyllithium (n-BuLi), and tetrahydrofuran (THF) at a molar ratio of n-BuLi/THF = 40. Next, 4.5 parts by weight of a styrene monomer was added and polymerized at 40°C. Thus, a copolymer (block A) was obtained. After the polymerization conversion rate of the styrene monomer reached about 100%, 91 parts by weight of a 1,3-butadiene monomer was added and polymerized. Thus, an AB block copolymer was obtained. After the polymerization conversion rate reached almost 100%, 4.5 parts by weight of a styrene monomer was further added and polymerized at 40°C until the polymerization conversion rate reached about 100%. Thus, an ABA block copolymer (before hydrogenation) was obtained.

The ABA block copolymer was diluted with purified and dried cyclohexane to a polymer concentration of 5% by weight, and subjected to hydrogenation. The hydrogenation was started at a hydrogen gas supply pressure of 0.7 MPa-Gauge and a reaction temperature of 80°C with stirring. When the absorption of hydrogen was completed, the temperature and pressure of the reaction solution were returned to normal temperature and normal pressure, and the reaction solution was taken out from the reaction vessel. Thus, an ABA block copolymer (1) was obtained.

The weight average molecular weight of the obtained ABA block copolymer (1) was measured by GPC. The measurement was performed using "2690 Separations Module" available from Waters as the measuring instrument, "GPC KF-806L" available from Showa Denko K. K. as the column, and ethyl acetate as the solvent, under the conditions of a sample flow rate of 1 mL/min and a column temperature of 40°C.

Measurement was performed on the obtained ABA block copolymer (1) using a differential scanning calorimeter (available from Hitachi High-Tech Science Co., Ltd., SII Exstar 6000/DSC6220) under a nitrogen atmosphere at a heating rate of 10°C/min. The glass transition temperature of the block B was obtained using the value obtained in the second run. A peak derived from the block A and a peak derived from the block B were obtained. The peak on the low temperature side was taken as the peak derived from the block B, and the glass transition temperature of the block B was determined.

For the obtained ABA block copolymer (1), the ratio of ethylene and butylene was calculated from the peak area ratio of ethylene and butylene components measured by $^1$H-NMR, and the SP values of the entire polymer and the block B were calculated.

(2) Preparation of adhesive solution

The obtained ABA block copolymer (1) was dissolved in toluene so that the solid content was 20% by weight. To 100 parts by weight of the ABA block copolymer (1) was added 8 parts by weight of Tinuvin 928 (benzotriazole UV absorber, available from BASF Japan) as an UV absorber, and the mixture was thoroughly stirred. Thus, an adhesive solution of an adhesive B was obtained.

(3) Confirmation of phase separation structure

An adhesive layer alone was produced in the same manner as in the examples and comparative examples described later. A small piece obtained by trimming the adhesive layer was dyed with a 2% osmic acid aqueous solution at 60°C for 12 hours, and then washed. Using a cryomicrotome (ULTRACUT FC7, available from LEICA), the small piece was cut in the thickness direction of the adhesive layer at a small-piece temperature of -100°C, whereby a section with a thickness of less than 100 nm was cut out. The cut section was placed on a sheet mesh covered with a support film. Thus, a measurement sample was prepared. Observation of the resulting measurement sample at a magnification of 5,000 times using a transmission electron microscope (JEM-2100, available from JEOL Ltd.) revealed that the measurement sample had a spherical phase separation structure.

(Adhesive C)

(1) Preparation of ABA block copolymer (2)

A two-necked flask was charged with 0.902 g of 1,6-hexanedithiol, 1.83 g of carbon disulfide, and 11 mL of dimethylformamide, followed by stirring at 25°C. To the flask was added dropwise 2.49 g of triethylamine over 15 minutes, followed by stirring at 25°C for three hours. Thereto was added dropwise 2.75 g of methyl-$\alpha$-bromophenylacetate over 15 minutes, followed by stirring at 25°C for four hours. Then, 100 mL of an extraction solvent (n-hexane:ethyl acetate = 50:50) and 50 mL of water were added to the reaction solution for extraction by separation. The organic layers obtained in the first and second extraction by separation were mixed and washed with 50 mL of 1 M hydrochloric acid, 50 mL of water, and 50 mL of saturated saline in the stated order. To the washed organic layer was added sodium sulfate for drying, and the sodium sulfate was filtered off and the filtrate was concentrated using an evaporator to remove the organic solvent. The obtained concentrate was purified by silica gel column chromatography to obtain a RAFT agent.

A two-necked flask was charged with 15 parts by weight of styrene (St), 2 parts by weight of acrylic acid (AAc), 1.9 parts by weight of the RAFT agent, and 2,2'-azobis(2-methylbutyronitrile) (ABN-E), and purged with nitrogen gas while the temperature inside was raised to 85°C. The mixture was stirred at 85°C for six hours for polymerization reaction (first stage reaction).

After completion of the reaction, 4,000 parts by weight of n-hexane was added to the flask and stirred to precipitate the reaction product. Unreacted monomers and the RAFT agent were filtered off, and the reaction product was dried under reduced pressure at 70°C. Thus, a copolymer (block A) was obtained.

A two-necked flask was charged with a mixture containing 81 parts by weight of butyl acrylate (BA), 2 parts by weight of acrylic acid (AAc), 0.058 parts by weight of ABN-E, and 50 parts by weight of ethyl acetate, and the copolymer (block A) obtained above, and purged with nitrogen gas while the temperature inside was raised to 85°C. The mixture was stirred at 85°C for six hours for polymerization reaction (second stage reaction) to obtain a reaction liquid containing a block copolymer including block A and block B.

To a portion sampled from the reaction solution was added 4,000 parts by weight of n-hexane, followed by stirring for precipitation of the reaction product. Unreacted monomers and the solvent were then filtered off, and the reaction product was dried under reduced pressure at 70°C. Thus, an ABA block copolymer (2) was obtained.

The weight average molecular weight of the obtained ABA block copolymer (2) was measured by GPC. The measurement was performed using "2690 Separations Module" available from Waters as the measuring instrument, "GPC KF-806L" available from Showa Denko K. K. as the column, and ethyl acetate as the solvent, under the conditions of a sample flow rate of 1 mL/min and a column temperature of 40°C.

Measurement was performed on the obtained ABA block copolymer (2) using a differential scanning calorimeter (SII Exstar 6000/DSC6220, available from Hitachi High-Tech Science Co., Ltd.) in a nitrogen atmosphere under the condition of a heating rate of 10°C/min. The glass transition temperature of the block B was obtained using the value obtained in the second run. A peak derived from the block A and a peak derived from the block B were obtained. The

peak on the low temperature side was taken as the peak derived from the block B, and the glass transition temperature of the block B was determined.

For the obtained ABA block copolymer (2), the SP values of the entire polymer and the block B were calculated by the Fedors method.

(2) Preparation of adhesive solution

The obtained ABA block copolymer (2) was dissolved in ethyl acetate so that the solid content was 15% by weight. To 100 parts by weight of the ABA block copolymer (2) were added 1 part by weight of Tetrad C (available from Mitsubishi Chemical Corporation) as an epoxy crosslinking agent and 8 parts by weight of Tinuvin 928 (benzotriazole UV absorber, available from BASF Japan), followed by sufficient stirring. Thus, an adhesive solution of an adhesive C was obtained.

(3) Confirmation of phase separation structure

An adhesive layer alone was produced in the same manner as in the examples and comparative examples described later. A small piece obtained by trimming the adhesive layer was dyed with a 2% osmic acid aqueous solution at 60°C for 12 hours, and then washed. Using a cryomicrotome (ULTRACUT FC7, available from LEICA), the small piece was cut in the thickness direction of the adhesive layer at a small-piece temperature of -100°C, whereby a section with a thickness of less than 100 nm was cut out. The cut section was placed on a sheet mesh covered with a support film. Thus, a measurement sample was prepared. Observation of the resulting measurement sample at a magnification of 5,000 times using a transmission electron microscope (JEM-2100, available from JEOL Ltd.) revealed that the measurement sample had a spherical phase separation structure.

(Adhesives D to E, J to O, and R)

Adhesive solutions were prepared as in the case of the adhesive C, except that the composition of the ABA block copolymer, the type or amount of the UV absorber, and the type or amount of the crosslinking agent were changed as shown in Table 1 or 2.

(Adhesives F to I, P, and Q)

Adhesive solutions were prepared as in the case of the adhesive A, except that the composition of the acrylic copolymer, the type or amount of the UV absorber, and the type or amount of the crosslinking agent were changed as shown in Table 1 or 2. In the case of the adhesive H, Tinuvin 460 (hydroxyphenyltriazine UV absorber, available from BASF Japan) was used as the UV absorber.

Alphabetical symbols in the tables are the abbreviations of the following compounds, respectively.

St: styrene
AAc: acrylic acid
BA: butyl acrylate
2-EHA: 2-ethylhexyl acrylate
LA: lauryl acrylate
MA: methyl acrylate
MOEA: methoxyethyl acrylate
2-HEA: 2-hydroxyethyl acrylate

[Table 1]

| | | | | Adhesive | | | | | | | | |
|---|---|---|---|---|---|---|---|---|---|---|---|---|
| | | | | A | B | C | D | E | F | G | H | I |
| | Type | | | Acrylic copolymer (1) | A-B-A block copolymer (1) | A-B-A block copolymer (2) | A-B-A block copolymer (3) | A-B-A block copolymer (4) | Acrylic copolymer (1) | Acrylic copolymer (1) | Acrylic copolymer (1) | Acrylic copolymer (2) |
| | Block A | Aromatic vinyl monomer (parts by weight) | St | - | 9 | 15 | 15 | 15 | - | - | - | - |
| | | Crosslinkable functional group-containing monomer (parts by weight) | AAc | - | - | 2 | 2 | 2 | - | - | - | - |
| | | | HEA | - | - | - | - | - | - | - | - | - |

(continued)

| | | | | Adhesive | | | | | | | | |
|---|---|---|---|---|---|---|---|---|---|---|---|---|
| | | | | A | B | C | D | E | F | G | H | I |
| Base polymer | Block B | (Meth)acrylic monomer (parts by weight) | BA | 98 | - | 81 | 20 | 40 | 98 | 98 | 98 | - |
| | | | | - | - | - | 61 | - | - | - | - | 50 |
| | | | 2-EHA LA | - | - | - | - | 41 | - | - | - | 49.6 |
| | | | MA | - | - | - | - | - | - | - | - | - |
| | | | MOEA | - | - | - | - | - | - | - | - | - |
| | | Crosslinkable functional group-containing monomer (parts by weight) | AAc | 2 | - | 2 | 2 | | 2 | 2 | 2 | 0.3 |
| | | | HEA | - | - | - | - | 2 | - | - | - | 0.1 |
| | | Conjugated diene monomer (parts by weight) | 1,3-Butadiene | - | 91 (Ethylene: Butylene = 40: 51 after hydroaenation) | - | - | - | - | - | - | - |
| | Mw (x $10^4$) | | | 80 | 23 | 25 | 31 | 29 | 80 | 80 | 80 | 50 |
| | Glass transition temperature of block B (°C) | | | - | -50 | -52 | -64 | -38 | - | - | - | - |
| | SP value of entire polymer | | | 9.84 | 8.5 | 9.92 | 9.57 | 9.66 | 9.84 | 9.84 | 9.84 | 92 |
| | SP value of block B | | | - | 8.4 | 9.85 | 9.44 | 9.55 | | | - | - |
| UV absorber | Tinuvin 928 (benzotriazole) | | | 8 | 8 | 8 | 8 | 8 | 0.5 | 20 | - | 8 |
| (parts by weiaht) | Tinuvin 460 Γhydroxyphenyltriazine) | | | - | - | - | - | - | - | - | 8 | - |
| Crosslinking agent | Coronate L | | | 3.6 | - | - | - | 1 | 3.6 | 3.6 | | 3 |

(continued)

| | | Adhesive | | | | | | | | |
|---|---|---|---|---|---|---|---|---|---|---|
| | | A | B | C | D | E | F | G | H | I |
| (parts by weiaht) | Tetrad C | - | - | 1 | 1 | - | - | - | 0.05 | - |
| Phase separation structure | | - | spherical | spherical | spherical | spherical | - | - | - | - |

[Table 2]

| | | | | Adhesive | | | | | | | | |
|---|---|---|---|---|---|---|---|---|---|---|---|---|
| | | | | J | K | L | M | N | O | P | Q | R |
| Base polymer | Type | | | A-B-Ablock copolymer (4) | A-B-Ablock copolymer (5) | A-B-Ablock copolymer (6) | A-B-Ablock copolymer (7) | A-B-Ablock copolymer (8) | A-B-Ablock copolymer (9) | Acrylic copolymer (1) | Acrylic copolymer (3) | A-B-Ablock copolymer (10) |
| | Block A | Aromatic vinyl monomer (parts by weight) | St | 15 | 28 | 22 | 15 | 15 | 15 | - | - | 15 |
| | | Crosslinkable functional group-containing monomer (parts by weight) | AAc | 2 | 4 | 3 | 2 | 2 | 2 | - | - | 1.8 |
| | | | HEA | - | - | - | - | - | - | - | - | 0.2 |
| | Block | (Meth)acrylic monomer (parts by weight) | BA | 40 | 66 | 73 | 40 | - | 20 | 98 | 39 | 81 |
| | | | 2-EHA | - | - | - | - | - | - | - | 55 | |
| | | | LA | 41 | - | - | - | 41 | 41 | - | - | - |
| | | | MA | - | - | - | 41 | - | - | - | 3 | - |
| | | | MOEA | | | | | 40 | 20 | - | - | - |
| | | Crosslinkable functional group-containing monomer (parts by weight) | AAc | 2 | 2 | 2 | 2 | 2 | 2 | 2 | 2 | 2 |
| | | | HEA | - | - | - | - | - | - | - | - | - |
| | | Conjugated diene monomer (parts by weight) | 1,3-Butadiene | - | - | - | - | - | - | - | - | - |

(continued)

| | | Adhesive | | | | | | | | |
|---|---|---|---|---|---|---|---|---|---|---|
| | | J | K | L | M | N | O | P | Q | R |
| | Mw (x $10^4$) | 29 | 10 | 15 | 25 | 43 | 37 | 80 | 90 | 25 |
| | Glass transition temperature of block B (°C) | -38 | -52 | -53 | -25 | -35 | -36 | - | - | -52 |
| | SP value of entire polymer | 9.65 | 9.99 | 9.95 | 10.22 | 9.78 | 9.71 | 9.84 | 9.55 | 9.92 |
| | SP value of block B | 9.53 | 9.87 | 9.86 | 10.23 | 9.69 | 9.61 | - | - | 9.85 |
| UV absorber (parts bvweiqht) | Tinuvin 928 (benzotriazole) | 8 | 8 | 8 | 8 | 8 | 8 | - | - | - |
| | Tinuvin 460 (hydroxyphenyltriazine) | - | - | - | - | - | - | - | - | - |
| Crosslinking agent (parts by weiqht) | Coronate L | - | - | - | - | - | - | 3.6 | 2.1 | 2.9 |
| | Tetrad C | 0.75 | 0.75 | 0.75 | 0.75 | 0.75 | 0.75 | - | - | - |
| Phase separation structure | | spherical | cvlindrical | cvlindrical | spherical | spherical | spherical | - | - | spherical |

(Example 1)

(1) Production of adhesive tape

The obtained adhesive solution of the adhesive A was applied to a corona-treated polyethylene terephthalate (PET) film having a thickness of 50 um and a haze of 3.8% as a substrate, using an applicator so that the dry film thickness was 16 um, followed by drying at 110°C for three minutes. Thus, an ablation layer was formed. The resulting laminate was used as a laminated film (a). Next, to the ablation layer side of the laminated film (a) was bonded a corona-treated PET film having a thickness of 4 um as a barrier layer. The resulting laminate was used as a laminated film (b).

Separately, the obtained adhesive solution of the adhesive A was applied to a release-treated surface of a release-treated release PET film having a thickness of 75 um, using an applicator so that the dry film thickness was 10 um, followed by drying at 110°C for three minutes. Thus, an adhesive layer was formed. This adhesive layer was bonded to the barrier layer side of the laminated film (b). The resulting laminate was allowed to stand under heating at 40°C for 48 hours. Thus, an adhesive tape including a substrate, an ablation layer, a barrier layer, a first adhesive layer, and a release PET film in this order was obtained.

(2) Measurement of breaking strength of first adhesive layer

A 500-um-thick sheet consisting only of the first adhesive layer was prepared separately. This adhesive layer was pulled at a tensile speed of 500 mm/min in an environment of a temperature of 23°C and a relative humidity of 50% in conformity with JIS K7161 using Autograph (available from Shimadzu Corporation). The breaking strength was calculated from the stress at break.

(3) Measurement of gel fractions of first adhesive layer and ablation layer

The first adhesive layer (adhesive composition) alone in an amount of 0.1 g and the ablation layer (ablation layer composition) alone in an amount of 0.1 g were taken out from the adhesive tape. They were separately immersed in 50 mL of ethyl acetate, and shaken using a shaker under the conditions of a temperature of 23°C and 200 rpm for 24 hours. After the shaking, ethyl acetate and the composition swollen by absorbing ethyl acetate were separated using a metal mesh (#200 mesh). The separated composition was dried under the condition of 110°C for one hour. The weight of each composition including the metal mesh after drying was measured, and the gel fractions of the first adhesive layer and the ablation layer were calculated using the following equation.

$$\text{Gel fraction (\% by weight)} = 100 \times (W_1 - W_2)/W_0$$

($W_0$: the initial weight of the composition, $W_1$: the weight of the composition including the metal mesh after drying, $W_2$: the initial weight of the metal mesh)

For the ablation layer of Example 3 and the first adhesive layer of Example 4, toluene was used instead of ethyl acetate to measure the gel fraction.

(4) Measurement of storage modulus (shear storage modulus) G' at 23°C and 1 Hz of ablation layer and storage moduli (shear storage moduli) at -20°C, 23°C, and 140°C and 1 Hz of first adhesive layer

A 1-mm-thick sheet consisting only of the ablation layer and a 1-mm-thick sheet consisting only of the first adhesive layer were separately prepared. For the ablation layer and the first adhesive layer, the storage moduli G' at -20°C, 23°C, and 140°C were determined in measurement of a dynamic viscoelasticity spectrum from -40°C to 160°C under the conditions 1 Hz in a simple heating mode of a heating rate of 5°C/min using a viscoelastic spectrometer DVA-200 (available from IT Keisoku Seigyo Co., Ltd.).

(5) Measurement of UV absorbance of ablation layer and first adhesive layer

The UV absorbances of the ablation layer and the first adhesive layer at a wavelength of 365 nm were measured in conformity with JIS L1925 using a spectrophotometer (UV-2600i, available from Shimadzu Corporation).

(6) Measurement of ball tack value of adhesive tape

The ball tack value of the adhesive tape was measured using a ball tack tester (available from Yasuda Seiki Seisakusho Co., Ltd.) in conformity with JIS Z0237 in an environment of a temperature of 23°C and a relative humidity

of 50%.

(7) Surface peel strength of first adhesive layer of adhesive tape

To the surface of the first adhesive layer of the adhesive tape was bonded one face of a 10-mm-side SUS cube, and pressure-bonded at 0.3 MPa for 10 seconds in an environment of a temperature of 23°C and a relative humidity of 50%. Then, the SUS cube was pulled at a tensile speed of 1,000 mm/min to be separated with the substrate side of the adhesive tape fixed, in an environment of a temperature of 23°C and a relative humidity of 50% using Autograph (available from Shimadzu Corporation). The maximum stress at the time of removal was measured as the surface peel strength.

(Examples 2 to 18, and 22 to 24, Comparative Examples 1 to 4)

Adhesive tapes were obtained in the same manner as in Example 1, except that the layers were changed as shown in Tables 3, 4, and 5. In Examples 15 to 18 and 22 to 24, the substrate used was a PET film having a thickness of 50 um and a haze of 0.3% and the barrier layer used was a 5.5-μm-thick PET film with an easy-adhesion resin layer (modulus of elasticity of easy-adhesion resin layer by nanoindentation: 5850 MPa).

(Example 19)

(1) Production of double-sided adhesive tape

The adhesive solution of the adhesive P was applied to a polyethylene terephthalate film one surface of which was release-treated, using an applicator so that the dry film thickness was 10 um, followed by drying at 110°C for three minutes. Thus, a laminated film (p) including an adhesive layer on the release-treated surface of the polyethylene terephthalate film was produced.

Next, an adhesive tape was produced as in Example 1 except that the layers were changed as shown in Table 4. The adhesive layer side of the laminated film (p) was laminated on the surface of the substrate of the adhesive tape, on the side opposite to the side on which the ablation layer, the barrier layer, the first adhesive layer, and the release PET film were laminated in this order. The adhesive layer of the laminated film (p) was transferred to be integrated with the substrate. In this manner, a double-sided adhesive tape provided with a second adhesive layer having the thickness and gel fraction shown in Table 4 was obtained.

The following were measured in the same manner as in Example 1: the breaking strength of the first adhesive layer; the gel fractions of the first adhesive layer and the ablation layer; the storage modulus (shear storage modulus) G' of the ablation layer at 23°C and 1 Hz and the storage moduli (shear storage moduli) G' of the first adhesive layer at -20°C, 23°C, and 140°C and 1 Hz; UV absorbances of the ablation layer and the first adhesive layer; ball tack value of the adhesive tape; and surface peel strength of the first adhesive layer of the adhesive tape.

The gel fraction of the second adhesive layer was measured by the same method as in "(3) Measurement of gel fractions of first adhesive layer and ablation layer".

(Examples 20 and 21)

Adhesive tapes were obtained as in Example 19, except that the layers were changed as shown in Table 4.

(2) Adhesion of second adhesive layer of adhesive tape

The double-sided adhesive tape obtained by the above method was cut to a width of 25 mm. To the surface of the first adhesive layer of the double-sided adhesive tape was bonded a 25-μm-thick PET film cut to a width of 30 mm. The surface of the second adhesive layer was bonded to a glass plate at a speed of 300 mm/min using a 2-kg pressure rubber roller at a room temperature of 23°C and a relative humidity of 50%. Using Autograph (available from Shimadzu Corporation), the second adhesive layer side of the double-sided adhesive tape was peeled off in a 180° direction at a speed of 300 mm/min in an environment of a temperature of 23°C and a relative humidity of 50% to measure the 180° adhesion.

<Evaluation>

The adhesive tapes obtained in the examples and comparative examples were evaluated as follows. The results are shown in Tables 3, 4 and 5.

(1) Laser ablation evaluation

(1-1-1) Chip component holdability and chip component separability

A wafer on which 10 Si chips (500 um × 500 um square, 50 um thick) were arranged were provided. To the Si chip side surface of the wafer was bonded the resulting adhesive tape. The Si chips were arranged on the adhesive tape by separating the wafer. A semiconductor solid-state laser was used to irradiate each Si chip with laser light at 365 nm with an output of 4 W and 4 kHz from the substrate side of the adhesive tape, whereby the Si chips were separated from the adhesive tape.

The evaluation on the chip component holdability was carried out based on the following criteria: "◦ (Good)" indicates that all Si chips were arranged on the adhesive tape from the wafer; "Δ (Fair)" indicates that 8 to 9 Si chips were arranged on the adhesive tape; and "× (Poor)" indicates that only 7 or less Si chips were arranged on the adhesive tape.

The evaluation on the chip component separability was carried out based on the following criteria: "◦◦ (Excellent)" indicates that all 10 Si chips were separated from the adhesive tape; "◦ (Good)" indicates that 8 to 9 Si chips were separated from the adhesive tape; "Δ (Fair)" indicates that 7 Si chips were separated from the adhesive tape; and "× (Poor)" indicates that only 6 or less Si chips were separated from the adhesive tape. When the adhesive tape included the second adhesive layer, the evaluation was performed with the second adhesive layer bonded to a 2-mm-thick glass support.

(1-1-2) Adhesive deposits

After the evaluation of the chip component holdability and the chip component separability, the surface of the Si chip separated from the adhesive tape was observed under a microscope to determine the presence or absence of adhesive deposits. The evaluation on the adhesive deposits was carried out based on the following criteria: "◦◦ (Excellent)" indicates that no adhesive deposits were observed; "◦ (Good)" indicates that adhesive deposits were observed in less than 20% of the area of the surface of the chip component; and "× (Poor)" indicates that adhesive deposits were observed in 20% or more of the area of the surface of the chip component.

(1-2-1) Small-sized chip component holdability and small-sized chip component separability

A wafer on which 10 small-sized Si chips (30 um × 40 um square, thickness 10 um) were arranged was provided. To the Si chip side surface of the wafer was bonded each of the adhesive tapes obtained in Examples 1 and 15 to 23. The Si chips were arranged on the adhesive tape by separating the wafer. A semiconductor solid-state laser was used to irradiate the Si chips with laser light at 365 nm with an output of 4 W and 4 kHz from the substrate side of the adhesive tape, whereby the Si chips were separated from the adhesive tape.

The evaluation on the chip component holdability was carried out based on the following criteria: "◦ (Good)" indicates that all Si chips were arranged on the adhesive tape from the wafer; "Δ (Fair)" indicates that 8 to 9 Si chips were arranged on the adhesive tape; and "× (Poor)" indicates that only 7 or less Si chips were arranged on the adhesive tape.

The evaluation on the (small-sized) chip component separability was carried out based on the following criteria: "◦◦ (Excellent)" indicates that all 10 Si chips were separated; "◦ (Good)" indicates that 8 to 9 Si chips were separated; and "× (Poor)" indicates that only 7 or less Si chips were separated from the adhesive tape. When the adhesive tape had a second adhesive layer, the evaluation was carried out with the second adhesive layer bonded to a 2-mm-thick glass support.

(1-2-2) Adhesive deposits on small-sized chip components

After the evaluation of the small-sized chip component holdability and the small-sized chip component separability, the surface of the Si chip separated from the adhesive tape was observed under a microscope to determine the presence or absence of adhesive deposits. The evaluation on the adhesive deposits was carried out based on the following criteria: "◦◦ (Excellent)" indicates that no adhesive deposits were observed; "◦ (Good)" indicates that adhesive deposits were observed in less than 20% of area of the surface of the chip component; and "× (Poor)" indicates that adhesive deposits were observed in 20% or more of area of the surface of the chip component.

(1-2-3) Detachment from glass support

For Examples 19 to 21, after the evaluation on the small-sized chip component holdability and the small-sized

chip component separability, the interface between the adhesive tape and the glass support was observed under a microscope to determine whether the second adhesive layer was detached from the support. The evaluation on the detachment from the support was carried out based on the following criteria: "◦ (Good)" indicates that no detachment was observed; and "× (Poor)" indicates that detachment was observed.

(2) Measurement of 180° adhesion and evaluation of end detachment

This evaluation was carried out only for the adhesive tapes obtained in Examples 5, 6, 8, 12, 13 and 14.
Using Autograph (available from Shimadzu Corporation), the substrate layer was peeled off from the barrier layer in a 180° direction at a tensile speed of 300 mm/min in an environment of a temperature of 23°C and a relative humidity of 50% in conformity with JIS Z0237 to measure the 180° adhesion (N/25 mm). The 180° adhesion between the substrate and the ablation layer and the 180° adhesion between the ablation layer and the barrier layer were measured.
An adhesive tape roll having a width of 1,000 mm and a length of 20 m was produced in the same manner as in each example. The roll was cut (slit) in the length direction to have a tape width of 300 mm. The presence or absence of detachment (end detachment) between the substrate and the barrier layer at the end (cut surface) of the adhesive tape after cutting was determined with an optical microscope (available from Keyence Corporation). The evaluation on the end detachment was carried out based on the following criteria: "◦ (Good)" indicates that no end detachment was observed; and "× (Poor)" indicates that end detachment was observed.

[Table 3]

| | | | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|---|
| Second adhesive layer | Adhesive | | - | - | - | - | - | - | - | - | - | - | - | - | - | - |
| | Thickness | | - | - | - | - | - | - | - | - | - | - | - | - | - | - |
| | Gel fraction | | - | - | - | - | - | - | - | - | - | - | - | - | - | - |
| Substrate | Material | | PET | PET | PET | PET | PET | PET | PET | PET | PET | PET | PET | PET | PET | PET |
| | Thickness | | 50 µm | 50 µm | 50 µm | 50 µm | 50 µm | 50 µm | 50 um | 50 µm | 50 µm | 50 µm | 50 µm | 50 µm | 23 µm | 50 um |
| | Haze | | 3.8% | 3.8% | 3.8% | 3.8% | 3.8% | 3.8% | 3.8% | 3.8% | 3.8% | 3.8% | 3.8% | 3.8% | 3.2% | 3.8% |
| Ablation layer | Adhesive | | A | A | B | A | A | C | C | D | E | F | A | G | G | H |
| | Thickness | | 16 µm | 16 µm | 16 µm | 16 µm | 16 µm | 16 µm | 16 µm | 16 µm | 16 µm | 16 µm | 16 µm | 8 µm | 8 µm | 8 µm |
| | Gel fraction | | 40% | 40% | 0% | 40% | 40% | 90% | 90% | 88% | 72% | 40% | 40% | 40% | 40% | 61% |
| | Storage modulus G' | | $5.8 \times 10^4$ Pa | $5.8 \times 10^4$ Pa | $3.0 \times 10^5$ Pa | $5.8 \times 10^4$ Pa | $5.8 \times 10^4$ Pa | $1.7 \times 10^5$ Pa | $1.7 \times 10^5$ Pa | $5.9 \times 10^4$ Pa | $2.9 \times 10^4$ Pa | $5.8 \times 10^4$ Pa | $5.8 \times 10^4$ Pa | $5.8 \times 10^4$ Pa | $5.8 \times 10^4$ Pa | $5.8 \times 10^4$ Pa |
| | UV absorbance | | 99% | 99% | 99% | 99% | 99% | 99% | 99% | 99% | 99% | 85% | 99% | 99% | 99% | 99% |
| Barrier layer | Material | | PET | PET | PET | PET | PET | PET | PET | PET | PET | PET | OPP | PET | PET | PET |
| | Thickness | | 4 µm | 12 µm | 4 µm | 4 µm | 4 µm | 4 µm | 4 µm | 4 µm | 4 µm | 4 µm | 20 µm | 4 µm | 4 µm | 4 µm |
| | Easy-adhesion resin layer | Thickness | - | - | - | - | - | - | - | - | - | - | - | - | - | - |

(continued)

| | | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|
| First adhesive layer | Adhesive | A | A | A | B | C | C | C | D | E | F | A | C | C | C |
| | Thickness | 10 μm | 10 μm | 10 μm | 10 μm | 10 μm | 10 μm | 25 μm | 10 μm | 10 μm | 10 μm | 10 μm | 8 μm | 8 μm | 8 μm |
| | Gel fraction | 89% | 89% | 89% | 0% | 92% | 92% | 92% | 88% | 65% | 89% | 89% | 92% | 92% | 92% |
| | Breaking strength | 0.4 MPa | 0.4 MPa | 0.4 MPa | 3.5 MPa | 2.OMPa | 2.0 MPa | 2.0 MPa | 1.4 MPa | 0.7 MPa | 0.4 MPa | 0.4 MPa | 2.0 MPa | 2.0 MPa | 2.0 MPa |
| | Storage modulus G' at 23°C | $5.8 \times 10^4$ Pa | $5.8 \times 10^4$ Pa | 5.8 μ $10^4$ Pa | $3.0 \times 10^5$ Pa | $17 \times 10^5$ Pa | $1.7 \times 10^5$ Pa | $17 \times 10^5$ Pa | $5.9 \times 10^4$ Pa | $2.9 \times 10^4$ Pa | $5.8 \times 10^4$ Pa | $5.8 \times 10^4$ Pa | $1.7 \times 10^5$ Pa | $17 \times 10^5$ Pa | $1.7 \times 10^5$ Pa |
| | Storage modulus G' at -20°C | $4.7 \times 10^5$ Pa | $4.7 \times 10^5$ Pa | $4.7 \times 10^5$ Pa | $8.8 \times 10^5$ Pa | $6.5 \times 10^6$ Pa | $6.5 \times 10^6$ Pa | $6.5 \times 10^6$ Pa | $4.8 \times 10^5$ Pa | $1.0 \times 10^5$ Pa | $4.7 \times 10^5$ Pa | $4.7 \times 10^5$ Pa | $6.5 \times 10^6$ Pa | $6.5 \times 10^6$ Pa | $6.5 \times 10^6$ Pa |
| | Storage modulus G' at 140°C | $2.0 \times 10^4$ Pa | $2.0 \times 10^4$ Pa | $2.0 \times 10^4$ Pa | $7.1 \times 10^4$ Pa | $1.0 \times 10^4$ Pa | $1.0 \times 10^4$ Pa | $1.0 \times 10^4$ Pa | $3.3 \times 10^4$ Pa | $1.8 \times 10^4$ Pa | $2.0 \times 10^4$ Pa | $2.0 \times 10^4$ Pa | $1.0 \times 10^4$ Pa | $1.0 \times 10^4$ Pa | $1.0 \times 10^4$ Pa |
| | UV absorbance | 99% | 99% | 99% | 99% | 99% | 99% | 99% | 99% | 99% | 70% | 99% | 99% | 99% | 99% |
| Ball tack value of adhesive tape | | 8 | 8 | 8 | 4 | 7 | 6 | 10 | 10 | 6 | 8 | 8 | 7 | 7 | 7 |
| Surface peel strength of first adhesive layer of adhesive tape | | 0.74 MPa | 0.75 MPa | 0.74 MPa | 0.62 MPa | 0.69 MPa | 0.70 MPa | 0.81 MPa | 0.69 MPa | 0.66 MPa | 0.78 MPa | 0.79 MPa | 0.67 MPa | 0.68 MPa | 0.68 MPa |
| Adhesion of second adhesive layer of adhesive tape | | - | - | - | - | - | - | - | - | - | - | - | - | - | - |

(continued)

| | | | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|---|
| Evaluation | 500 μm × 500 μm square | holdabilitv | ○ | ○ | ○ | △ | ○ | ○ | ○ | ○ | ○ | ○ | ○ | ○ | ○ | ○ |
| | | Chipcomponent Chip component separability | ○○ | ○ | △ | ○ | ○○ | ○○ | ○○ | ○○ | ○○ | ○ | ○ | ○○ | ○○ | ○○ |
| | | Adhesive deposits | ○ | ○ | ○ | ○○ | ○○ | ○○ | ○○ | ○○ | ○ | ○ | ○ | ○○ | ○○ | ○○ |
| | 30 μm × 40 μm square | Chip component holdabilitv | ○ | - | - | - | - | - | - | - | - | - | - | - | - | - |
| | | Chip component separability | △ | - | - | - | - | - | - | - | - | - | - | - | - | - |
| | | Adhesive deposits | △ | - | - | - | - | - | - | - | - | - | - | - | - | - |
| | | Detachment from glass support | - | - | - | - | - | - | - | - | - | - | - | - | - | - |
| | 180° adhesion | between substrate and laver | - | - | - | - | 18.1 N/25 mm | 5.5 N/25 mm | - | 6.6 N/25 mm | - | - | - | 10.5 N/25 mm | 9.8 N/25 mm | 6.8 N/25 mm |
| | | ablation between ablation layer and barrier laver | - | - | - | - | 18.1 N/25 mm | 5.5 N/25 mm | - | 6.6 N/25 mm | - | - | - | 10.5 N/25 mm | 9.8 N/25 mm | 6.8 N/25 mm |
| | End detachment | | - | - | - | - | ○ | × | - | ○ | - | - | - | ○ | ○ | ○ |

[Table 4]

| | | | Example 15 | Example 16 | Example 17 | Example 18 | Example 19 | Example 20 | Example 21 | Example 22 | Example 23 | Example 24 |
|---|---|---|---|---|---|---|---|---|---|---|---|---|
| Second adhesive layer | Adhesive | | - | - | - | - | P | Q | R | - | - | |
| | Thickness | | - | - | - | - | 10 μm | 10 μm | 10 μm | - | - | - |
| | Gel fraction | | - | - | - | - | 40% | 37% | 43% | - | - | - |
| Substrate | Material | | PET | PET | PET | PET | PET | PET | PET | PET | PET | PET |
| | Thickness | | 50 μm | 50 μm | 50 μm | 50 μm | 50 μm | 50 μm | 50 μm | 50 μm | 50 μm | 50 μm |
| | Haze | | 0.3 | 0.3 | 0.3 | 0.3 | 0.3 | 0.3 | 0.3 | 0.3 | 0.3 | 0.3 |
| Ablation layer | Adhesive | | J | J | J | J | J | J | J | N | O | I |
| | Thickness | | 8 μm | 8 μm | 8 μm | 8 μm | 8 μm | 8 μm | 8 μm | 8 μm | 8 μm | 8 μm |
| | Gel fraction | | 82% | 82% | 82% | 82% | 82% | 82% | 82% | 80% | 83% | 73% |
| | Storage modulus G' | | $4.3 \times 10^4$ Pa | $4.3 \times 10^4$ Pa | $4.3 \times 10^4$ Pa | $4.3 \times 10^4$ Pa | $4.3 \times 10^4$ Pa | $4.3 \times 10^4$ Pa | $4.3 \times 10^4$ Pa | $4.3 \times 10^4$ Pa | $4.3 \times 10^4$ Pa | $1.8 \times 10^4$ Pa |
| | UV absorbance | | 99% | 99% | 99% | 99% | 99% | 99% | 99% | 99% | 99% | 99% |
| Barrier layer | Material | | PET | PET | PET | PET | PET | PET | PET | PET | PET | PET |
| | Thickness | | 5.5 μm | 5.5 μm | 5.5 μm | 5.5 μm | 5.5 μm | 5.5 μm | 5.5 μm | 5.5 μm | 5.5 μm | 5.5 μm |
| | Easy-adhesion resin layer | Thickness | 0.12 μm | 0.12 μm | 0.12 μm | 0.12 μm | 0.12 μm | 0.12 μm | 0.12 μm | 0.12 μm | 0.12 μm | 0.12 μm |

(continued)

| | | Example 15 | Example 16 | Example 17 | Example 18 | Example 19 | Example 20 | Example 21 | Example 22 | Example 23 | Example 24 |
|---|---|---|---|---|---|---|---|---|---|---|---|
| First adhesive layer | Adhesive | C | K | L | M | K | K | K | L | L | I |
| | Thickness | 8 μm | 8 μm | 8 μm | 8 um | 8 μm | 8 μm | 8 μm | 8 μm | 8 μm | 8 μm |
| | Gel fraction | 92% | 86% | 91% | 94% | 86% | 86% | 86% | 91% | 91% | 73% |
| | Breaking strength | 2.0 MPa | 6.3 MPa | 4.4 MPa | 6.1 MPa | 6.3 MPa | 6.3 MPa | 6.3 MPa | 4.4 MPa | 4.4 MPa | 0.1 MPa |
| | Storage modulus G' at 23°C | $1.7 \times 10^5$ Pa | $1.1 \times 10^6$ Pa | $27 \times 10^5$ Pa | $1.1 \times 10^6$ Pa | $1.1 \times 10^6$ Pa | $1.1 \times 10^6$ Pa | $1.1 \times 10^6$ Pa | $2.7 \times 10^5$ Pa | $27 \times 10^5$ Pa | $1.8 x 10^4$ Pa |
| | Storage modulus G' at -20°C | $6.5 \times 10^6$ Pa | $13 \times 10^7$ Pa | $1.3 \times 10^7$ Pa | $52 \times 10^6$ Pa | $1.3 \times 10^7$ Pa | $1.3 \times 10^7$ Pa | $1.3 \times 10^7$ Pa | $1.3 \times 10^7$ Pa | $1.3 \times 10^7$ Pa | $1.8 \times 10^5$ Pa |
| | Storage modulus G' at 140°C | $1.0 \times 10^4$ Pa | $92 \times 10^4$ Pa | $8.8 \times 10^4$ Pa | $1.8 \times 10^5$ Pa | $92 \times 10^4$ Pa | $9.2 \times 10^4$ Pa | $92 \times 10^4$ Pa | $8.8 \times 10^4$ Pa | $8.8 \times 10^4$ Pa | $1.4 \times 10^4$ Pa |
| | UV absorbance | 99% | 99% | 99% | 99% | 99% | 99% | 99% | 99% | 99% | 99% |
| Ball tack value of adhesive tape | | 7 | less than 4 | less than 4 | less than 4 | less than 4 | less than 4 | less than 4 | less than 4 | less than 4 | 12 |
| Surface peel strength of first adhesive layer of adhesive tape | | 0.68 MPa | 0.45 MPa | 0.51 MPa | 0.71 MPa | 0.45 MPa | 0.45 MPa | 0.45 MPa | 0.51 MPa | 0.51 MPa | 0.33 MPa |
| Adhesion of second adhesive layer of adhesive tape | | - | - | - | - | 3.3 W25 mm | 6.4 W25 mm | 14.2 N25 mm | - | - | - |

(continued)

| | | | Example 15 | Example 16 | Example 17 | Example 18 | Example 19 | Example 20 | Exam ple 21 | Example 22 | Example 23 | Example 24 |
|---|---|---|---|---|---|---|---|---|---|---|---|---|
| Evaluation | 500 μm × 500 μm square | Chip component holdability | ○ | △ | △ | △ | △ | △ | △ | △ | △ | ○ |
| | | Chip component separability | ○○ | ○○ | ○○ | ○○ | ○○ | ○○ | ○○ | ○○ | ○○ | ○○ |
| | | Adhesive deposits | ○○ | ○○ | ○○ | ○○ | ○○ | ○○ | ○○ | ○○ | ○○ | ○ |
| | 30 μm × 40 μm square | Chip component holdabilitv | ○ | ○ | ○ | ○ | ○ | ○ | ○ | ○ | ○ | - |
| | | Chip component separability | ○ | ○○ | ○ | ○○ | ○○ | ○○ | ○○ | ○○ | ○○ | - |
| | | Adhesive deposits | ○ | ○○ | ○○ | ○○ | ○○ | ○○ | ○○ | ○○ | ○○ | |
| | | Detachment from glass support between substrate | - | - | - | - | × | ○ | ○ | - | - | - |
| | 180° adhesion | and ablation layer | - | - | - | - | - | - | - | - | - | - |
| | | between ablation layer and barrier layer | - | - | - | - | - | - | - | - | - | - |
| | End detachment | | - | - | - | - | - | - | - | - | - | - |

[Table 5]

| | | | Comparative Example 1 | Comparative Example 2 | Comparative Example 3 | Comparative Example 4 |
|---|---|---|---|---|---|---|
| Second adhesive layer | Adhesive | | - | - | - | - |
| | Thickness | | - | - | - | - |
| | Gel fraction | | - | - | - | - |
| Substrate | Material | | PET | PET | PET | PET |
| | Thickness | | 50 μm | 50 μm | 50 μm | 50 μm |
| | Haze | | 3.8% | 3.8% | 3.8% | 3.8% |
| Ablation layer | Adhesive | | | A | | |
| | Thickness | | | 16μm | | |
| | Gel fraction | | - | 40% | - | - |
| | Storage modulus G' | | | $5.8 \times 10^4$ Pa | | |
| | UV absorbance | | | 99% | | |
| Barrier layer | Material | | - | - | - | - |
| | Thickness | | | | | |
| | Easy-adhesion resin | Thickness | - | - | - | - |
| First adhesive layer | Adhesive | | A | A | A | K |
| | Thickness | | 20 μm | 10 μm | 100 μm | 8 μm |
| | Gel fraction | | 89% | 89% | 89% | 86% |
| | Breaking strength | | 0.4 MPa | 0.4 MPa | 0.4 MPa | 6.3 MPa |
| | Storage modulus G' at 23°C | | $5.8 \times 10^4$ Pa | $5.8 \times 10^4$ Pa | $5.8 \times 10^4$ Pa | $1.1 \times 10^6$ Pa |
| | Storage modulus G' at -20°C | | $4.7 \times 10^5$ Pa | $4.7 \times 10^5$ Pa | $4.7 \times 10^5$ Pa | $1.3 \times 10^7$ Pa |
| | Storage modulus G' at 140°C | | $2.1 \times 10^4$ Pa | $2.1 \times 10^4$ Pa | $2.1 \times 10^4$ Pa | $9.2 \times 10^4$ Pa |
| | UV absorbance | | 99% | 99% | 99% | 99% |
| Ball tack value of adhesive tape | | | 6 | 10 | 14 | less than 4 |
| Surface peel strength of first adhesive layer of adhesive tape | | | 0.79 MPa | 0.82 MPa | 1.05 MPa | 0.51 MPa |
| Adhesion of second adhesive layer of adhesive tape | | | - | - | - | - |

(continued)

| | | | Comparative Example 1 | Comparative Example 2 | Comparative Example 3 | Comparative Example 4 |
|---|---|---|---|---|---|---|
| Evaluation | 500 µm × 500 µm square | Chip component holdability | ○ | ○ | ○ | △ |
| | | Chip component separability | ○○ | ○○ | △ | △ |
| | | Adhesive deposits | x | × | × | ○ |
| | 30 µm × 40 µm square | Chip component holdability | - | - | - | - |
| | | Chip component separability | - | - | - | - |
| | | Adhesive deposits | - | - | - | - |
| | | Detachment from glass support | - | - | - | - |
| | 180° adhesion | between substrate and ablation layer | - | - | - | - |
| | | between ablation layer and barrier layer | - | - | - | - |
| | End detachment | | - | - | - | - |

INDUSTRIAL APPLICABILITY

The present invention can provide an adhesive tape for semiconductor device production which exhibits excellent chip component separability and can reduce adhesive deposits on chip components.

REFERENCE SIGNS LIST

1 chip component
1a electrode
4 adhesive layer
4a first adhesive layer
4b second adhesive layer
5 substrate
7 drive circuit board
7a electrode
8 laser light irradiation device
8a laser light
9 laminate of substrate and adhesive layer
10 ablation layer

11 barrier layer
12 adhesive tape for semiconductor device production

## Claims

1. An adhesive tape for semiconductor device production, comprising:

   a substrate;
   an ablation layer;
   a barrier layer; and
   a first adhesive layer in this order.

2. The adhesive tape for semiconductor device production according to claim 1, wherein the substrate is a resin film.

3. The adhesive tape for semiconductor device production according to claim 2, wherein the resin film is a polyester film.

4. The adhesive tape for semiconductor device production according to claim 1, 2, or 3, wherein the ablation layer has an UV absorbance at a wavelength of 365 nm of 90% or higher.

5. The adhesive tape for semiconductor device production according to claim 1, 2, 3, or 4, wherein the ablation layer has a storage modulus G' at 23°C of $1 \times 10^4$ Pa or more and $2 \times 10^5$ Pa or less.

6. The adhesive tape for semiconductor device production according to claim 1, 2, 3, 4, or 5, wherein the barrier layer has a thickness of 25 um or less.

7. The adhesive tape for semiconductor device production according to claim 6, wherein the barrier layer has a thickness of 6 um or less.

8. The adhesive tape for semiconductor device production according to claim 1, 2, 3, 4, 5, 6, or 7, wherein the barrier layer is a polyester film.

9. The adhesive tape for semiconductor device production according to claim 1, 2, 3, 4, 5, 6, 7, or 8, wherein the barrier layer has an easy-adhesion resin layer on a surface in contact with the first adhesive layer.

10. The adhesive tape for semiconductor device production according to claim 1, 2, 3, 4, 5, 6, 7, 8, or 9, wherein the first adhesive layer has a breaking strength of 1 MPa or more.

11. The adhesive tape for semiconductor device production according to claim 1, 2, 3, 4, 5, 6, 7, 8, 9, or 10, wherein the first adhesive layer has a storage modulus G' at 23°C of $1 \times 10^4$ Pa or more and $2 \times 10^5$ Pa or less.

12. The adhesive tape for semiconductor device production according to claim 1, 2, 3, 4, 5, 6, 7, 8, 9, 10, or 11, wherein the first adhesive layer contains an ABA block copolymer.

13. The adhesive tape for semiconductor device production according to claim 12, wherein the ABA block copolymer includes a block A containing a structure derived from an aromatic vinyl monomer and a block B containing a structure derived from a (meth)acrylic monomer.

14. The adhesive tape for semiconductor device production according to claim 12 or 13, wherein the block B has a structure derived from a crosslinkable functional group-containing monomer.

15. The adhesive tape for semiconductor device production according to claim 1, 2, 3, 4, 5, 6, 7, 8, 9, 10, 11, 12, 13, or 14, wherein the first adhesive layer has a gel fraction of 70% by weight or more and 95% by weight or less.

16. The adhesive tape for semiconductor device production according to claim 1, 2, 3, 4, 5, 6, 7, 8, 9, 10, 11, 12, 13, 14, or 15,

wherein the first adhesive layer has a thickness of 5 um or more and 30 um or less.

**17.** The adhesive tape for semiconductor device production according to claim 1, 2, 3, 4, 5, 6, 7, 8, 9, 10, 11, 12, 13, 14, 15, or 16,
wherein the adhesive tape for semiconductor device production has a ball tack value of 5 or higher.

**18.** The adhesive tape for semiconductor device production according to claim 1, 2, 3, 4, 5, 6, 7, 8, 9, 10, 11, 12, 13, 14, 15, 16, or 17,
wherein the first adhesive layer in the adhesive tape for semiconductor device production has a surface peel strength of 1 MPa or less.

**19.** The adhesive tape for semiconductor device production according to claim 1, 2, 3, 4, 5, 6, 7, 8, 9, 10, 11, 12, 13, 14, 15, 16, 17, or 18,
wherein an adhesion between the substrate and the ablation layer is 6 N/25 mm or more.

**20.** The adhesive tape for semiconductor device production according to claim 1, 2, 3, 4, 5, 6, 7, 8, 9, 10, 11, 12, 13, 14, 15, 16, 17, 18, or 19,
wherein an adhesion between the ablation layer and the barrier layer is 6 N/25 mm or more.

**21.** The adhesive tape for semiconductor device production according to claim 1, 2, 3, 4, 5, 6, 7, 8, 9, 10, 11, 12, 13, 14, 15, 16, 17, 18, 19, or 20,
wherein the first adhesive layer is a curable adhesive layer.

**22.** The adhesive tape for semiconductor device production according to claim 1, 2, 3, 4, 5, 6, 7, 8, 9, 10, 11, 12, 13, 14, 15, 16, 17, 18, 19, 20, or 21, further comprising a second adhesive layer,
wherein the adhesive tape for semiconductor device production includes the second adhesive layer, the substrate, the ablation layer, the barrier layer, and the first adhesive layer in this order.

**23.** The adhesive tape for semiconductor device production according to claim 1, 2, 3, 4, 5, 6, 7, 8, 9, 10, 11, 12, 13, 14, 15, 16, 17, 18, 19, 20, 21 or 22, which is for use in production of a semiconductor device, the production including a step of irradiation with laser light.

FIG.1

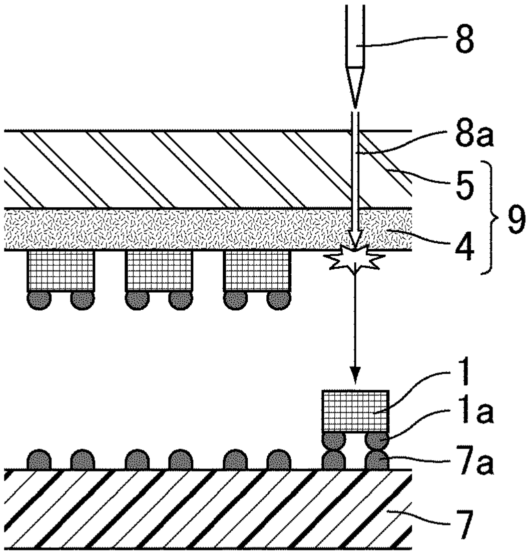


FIG.2

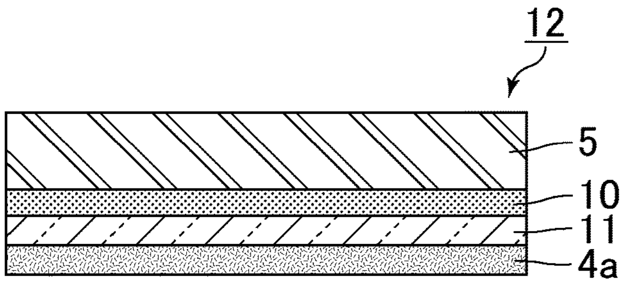


FIG.3

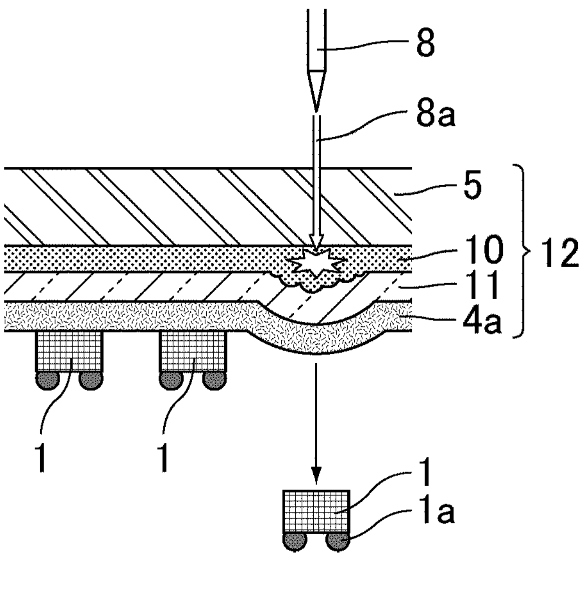

FIG.4

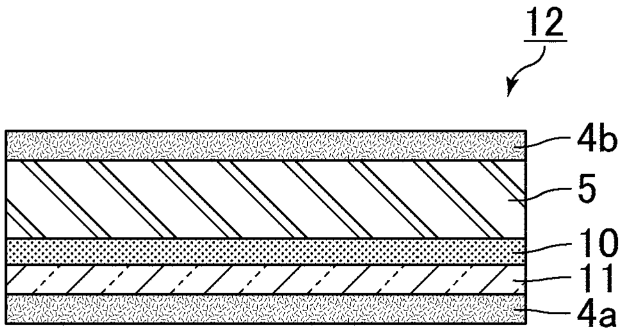

**INTERNATIONAL SEARCH REPORT**

International application No.
**PCT/JP2022/033300**

**A. CLASSIFICATION OF SUBJECT MATTER**

***B32B 27/00***(2006.01)i; ***B32B 27/36***(2006.01)i; ***C09J 153/00***(2006.01)i; ***C09J 201/00***(2006.01)i; ***C09J 7/25***(2018.01)i; ***C09J 7/29***(2018.01)i; ***C09J 7/38***(2018.01)i; ***B32B 7/022***(2019.01)i; ***B32B 7/023***(2019.01)i
FI: C09J7/29; C09J7/38; C09J7/25; C09J201/00; C09J153/00; B32B27/00 M; B32B27/36; B32B7/023; B32B7/022

According to International Patent Classification (IPC) or to both national classification and IPC

**B. FIELDS SEARCHED**

Minimum documentation searched (classification system followed by classification symbols)

B32B27/00; B32B27/36; C09J153/00; C09J201/00; C09J7/25; C09J7/29; C09J7/38; B32B7/022; B32B7/023

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2002-121510 A (NITTO DENKO CORP.) 26 April 2002 (2002-04-26) entire text, all drawings | 1-23 |
| A | JP 2019-138949 A (V TECHNOLOGY CO., LTD.) 22 August 2019 (2019-08-22) entire text, all drawings | 1-23 |
| A | JP 2019-15899 A (V TECHNOLOGY CO., LTD.) 31 January 2019 (2019-01-31) entire text, all drawings | 1-23 |
| A | JP 2003-7986 A (SONY CORP.) 10 January 2003 (2003-01-10) entire text, all drawings | 1-23 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 November 2022** | **15 November 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/033300**

| Patent document cited in search report | Publication date (day/month/year) | Patent family member(s) | Publication date (day/month/year) |
|---|---|---|---|
| JP 2002-121510 A | 26 April 2002 | US 2004/0003883 A1<br>entire text, all drawings<br>WO 2002/033017 A2<br>EP 1328601 A1<br>CN 1471565 A<br>KR 10-0718364 B1 | |
| JP 2019-138949 A | 22 August 2019 | US 2020/0402867 A1<br>entire text, all drawings<br>WO 2019/155848 A1<br>CN 111684510 A<br>KR 10-2020-0115505 A | |
| JP 2019-15899 A | 31 January 2019 | WO 2019/013120 A1<br>CN 110832572 A<br>KR 10-2020-0019133 A | |
| JP 2003-7986 A | 10 January 2003 | US 2003/0162463 A1<br>entire text, all drawings<br>WO 2002/084631 A1<br>KR 10-0853410 B1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2019138949 A
- JP 2019015899 A
- JP 2003007986 A

### Non-patent literature cited in the description


- **R. F. FEDORS.** *Polym. Eng. Sci.,* 1974, vol. 14 (2), 147-154
- **NOBUYUKI OTSU.** An Automatic Threshold Selection Method. Based on Discriminant and Least Squares Criteria. *The IEICE transactions on information and systems,* vol. J63-D (4), 349-356